# FASCICULE DE BREVET EUROPEEN

(11) **EP 3 707 521 B1**
(45) Date de publication et mention de la délivrance du brevet: **06.10.2021**
(21) Numéro de dépôt: 18814892.8
(22) Date de dépôt: 06.12.2018
(51) Int. Cl.: G01R 31/327, H01H 71/04

(54) **PROCEDE DE DETECTION DE L'ETAT D'UN APPAREIL DE PROTECTION ELECTRIQUE DANS UNE INSTALLATION ELECTRIQUE ET DISPOSITIF DE DETECTION METTANT EN OEUVRE LEDIT PROCEDE**
VERFAHREN ZUR ERKENNUNG DES ZUSTANDES EINES ELEKTRONISCHEN SCHUTZGERÄTS IN EINER ELEKTRISCHEN ANLAGE UND DETEKTOR MIT DIESEM VERFAHREN
METHOD FOR DETECTING THE STATE OF AN ELECTRONIC PROTECTIVE APPLIANCE IN AN ELECTRICAL FACILITY AND DETECTION DEVICE IMPLEMENTING SAID METHOD

(30) Priorité: 07.12.2017 FR 1761739
(43) Date de publication de la demande: 16.09.2020
(73) Titulaire: Socomec, 67230 Benfeld (FR)
(72) Inventeur: CAPOT, Marc, 67600 Kintzheim (FR); HERR, Pierre-Henri, 67140 Barr (FR); KERN, Christian, 68240 Kaysersberg Vignoble (FR)
(74) Mandataire: Cabinet Laurent & Charras
(86) Numéro de dépôt international: PCT/EP2018/083744
(87) Numéro de publication internationale: WO 2019/110711

(56) Documents cités:
- US-A1- 2015 070 026
- US-A1- 2017 269 128

## Description

### Domaine technique :

La présente invention concerne un procédé de détection de l'état ouvert ou fermé d'un appareil de protection électrique dans une installation électrique, ladite installation comportant au moins un détecteur de tension amont et un détecteur de tension aval disposés respectivement en amont et en aval dudit appareil de protection.

Elle concerne également un dispositif de détection de l'état ouvert ou fermé d'un appareil de protection électrique dans une installation électrique permettant la mise en œuvre du procédé ci-dessus.

### Technique antérieure :

On appelle « appareil de protection électrique » tout appareil ou organe de type disjoncteur, fusible, interrupteur fusible, relais électromécanique, ou similaire, ayant pour fonction principale d'assurer la protection des personnes, des charges et des circuits électriques, en coupant automatiquement le courant qui les traverse en cas de défaut tel que :
- une surcharge, qui survient lorsque la puissance demandée au circuit dépasse sa capacité, généralement parce qu'on a branché trop de charges sur le circuit. Il en résulte un échauffement des câbles et un risque d'incendie, ou de :
- un court-circuit, qui est un contact fortuit entre phase et neutre dans un câble ou dans une charge défectueuse. Si le circuit concerné n'était pas coupé immédiatement, il en résulterait des dégâts sur l'installation et des risques d'électrocution pour les personnes.

On appelle « installation électrique » toute installation de câblage sous terre, horsterre ou dans un bâtiment, pour la transmission d'un point à un autre de l'énergie provenant d'un réseau électrique pour l'alimentation de toute charge consommatrice d'énergie électrique, y compris la connexion du câblage à cette charge. Une installation électrique peut être monophasée ou polyphasée, à un seul niveau de distribution ou à plusieurs niveaux de distribution hiérarchisés. Dans le cas d'une installation électrique à multi-niveaux, un appareil de protection est généralement prévu à chaque niveau de distribution, respectivement dans un tableau électrique principal suivi de tableaux électriques divisionnaires puis de tableaux électriques terminaux. La charge peut être constituée par tout équipement et appareillage électrique, aussi bien industriel, tertiaire que domestique.

Les opérations de maintenance et de surveillance d'une installation électrique nécessitent d'avoir une connaissance précise et en temps réel de l'état d'ouverture ou de fermeture des appareils de protection électrique permettant de connaître l'état de fonctionnement de ladite installation et de déclencher en cas de besoin l'intervention d'un opérateur en toute sécurité. D'autre part, en cas de déclenchement d'un appareil de protection électrique, l'opérateur doit pouvoir en identifier la cause afin d'y remédier dans les meilleurs délais. Les installations électriques dans l'industrie et le tertiaire sont généralement surveillées et pilotées par une centrale de supervision qui peut être sur place ou déportée. Dans tous les cas, les données collectées telles que les paramètres de fonctionnement de l'installation doivent être transmises à cette centrale de supervision via une connexion filaire ou non, par exemple au moyen d'un bus de communication, ou d'un protocole de communication.

Jusqu'à présent la seule solution permettant de déterminer l'état ouvert ou fermé d'un appareil de protection consiste pour le fabricant à équiper les appareils de protection de contacts auxiliaires dédiés à cette fonction, et pour l'utilisateur à câbler ces contacts auxiliaires sur un appareil de mesure et/ou un automate et/ou une centrale de mesure et de surveillance. A cet effet, deux contacts auxiliaires sont nécessaires pour connaitre l'état complet d'un appareil de protection, à savoir un premier contact auxiliaire permettant de connaître l'état physique dudit appareil (état ouvert ou état fermé) et un second contact auxiliaire permettant de connaitre la cause de déclenchement dudit appareil "pas de déclenchement" ou "déclenchement" causé par une surcharge, un court-circuit, un défaut différentiel, une surtension, un retour de puissance, ou toute autre cause équivalente. Selon les besoins, un seul contact auxiliaire peut suffire selon que l'on souhaite connaitre uniquement l'état physique de l'appareil ou uniquement la cause de son déclenchement.

Cette solution de câblage de contacts auxiliaires présente des inconvénients aussi bien en termes de coût de mise en œuvre que de sécurité et de fiabilité, notamment dans le cas d'une installation électrique comportant une pluralité d'appareils de protection. En effet, l'opération de câblage des contacts auxiliaires implique d'ajouter de nombreux câbles additionnels dans les tableaux électriques, qui est une opération complexe, fastidieuse, onéreuse et source d'erreurs pouvant fausser les informations récoltées. Par ailleurs, ces câbles additionnels et ces contacts auxiliaires occupent un volume important dans les armoires électriques, lesquelles doivent être dimensionnées en conséquence. Enfin, le fait d'équiper les appareils de protection électrique de contacts auxiliaires renchérit leur coût de fabrication.

On connait par ailleurs de la publication US 2015/070026 A1, une solution permettant d'identifier la cause d'une perte de tension en aval d'un disjoncteur au moyen d'un appareil auxiliaire raccordé par câblage au disjoncteur du côté de la charge. L'appareil auxiliaire comprend un capteur de courant et un capteur de tension pour mesurer l'intensité et la tension en aval du disjoncteur dans le but de détecter une perte de tension en aval du disjoncteur et de déterminer la cause de cette perte de tension par analyse de l'échauffement calculé à partir de la mesure du courant permettant d'identifier si la cause provient d'une surcharge électrique, d'un court-circuit, ou d'une chute de tension. Cette solution propose un diagnostic de l'installation très incomplet, voire dangereux pour les personnes car certains défauts ne sont pas identifiés. En effet, elle ne permet pas de détecter l'état d'ouverture ou de fermeture des appareils de protection qui sont des données essentielles pour connaître avec précision et en temps réel l'état de fonctionnement d'une installation et de déclencher en cas de besoin l'intervention d'un opérateur en toute sécurité. De plus, cette solution ne permet pas de s'affranchir des problèmes liés au câblage.

La publication US 2017/269128 A1 propose une solution permettant de détecter l'absence de tension en amont d'un disjoncteur à l'aide d'un appareil de test auxiliaire raccordé par câblage à demeure dans l'installation, pour vérifier l'absence de risques électriques avant d'accéder à l'installation. Même si une des solutions décrites prévoit d'améliorer les fonctionnalités de l'appareil de test en détectant la présence et l'absence de tension en amont et en aval du disjoncteur, au moyen d'un ou de plusieurs appareils de test, elle ne permet pas non plus d'obtenir un diagnostic complet, précis et en temps réel de l'installation, puisqu'elle ne permet pas d'identifier l'état physique du disjoncteur. En effet, l'absence de tension en amont d'un disjoncteur ne suffit pas pour conclure en l'absence de risques électriques et peut induire des risques élevés pour les personnes. En outre, cette solution ne permet pas de s'affranchir des problèmes liés au câblage. On trouvera d'autres informations sur l'état de la technique dans les documents US2015/091604, US6282499 et EP3033760 qui utilisent la mesure des tensions en amont et en aval du disjoncteur ou d'un interrupteur, mais à d'autres fins que l'invention.

Il n'existe pas à ce jour d'autre solution globale permettant de résoudre ces problèmes.

### Exposé de l'invention :

La présente invention vise à pallier ces inconvénients en proposant un nouveau procédé de détection permettant de s'affranchir des contacts auxiliaires et par conséquent du câblage inhérent à ces contacts auxiliaires, offrant ainsi une solution de détection plus économique et plus légère, dont la mise en œuvre est simplifiée et plus rapide, puisqu'elle ne nécessite plus de câblage de contacts auxiliaires, dont les résultats obtenus sont obligatoirement plus fiables puisqu'il n'y a plus de risque d'erreur de câblage, et permettant d'obtenir des informations additionnelles sur les causes d'un déclenchement. La conception et le coût des appareils de protection électrique peuvent ainsi être optimisés, ainsi que ceux des tableaux électriques dont l'encombrement peut être réduit. De plus, la mise en œuvre de l'invention dans des installations électriques à plusieurs niveaux est grandement simplifiée.

Dans ce but, l'invention concerne un procédé de détection tel que défini dans la revendication 1.

Si l'appareil de protection électrique comporte plusieurs pôles et ladite installation comporte sur chacun des pôles un détecteur de tension amont et un détecteur de tension aval disposés respectivement en amont et en aval dudit appareil de protection, alors l'on peut exploiter les données de tension fournies par lesdits détecteurs de tension pôle par pôle pour disposer d'informations sur la présence ou l'absence de la tension en amont et sur la présence ou l'absence de la tension en aval dudit appareil de protection, l'on peut comparer les données de tension pôle par pôle, et l'on peut en outre déterminer si ledit appareil de protection est dans un état ouvert incomplet.

Si l'installation électrique comporte un nombre N d'appareils de protection électrique, l'on peut prévoir un unique détecteur de tension amont disposé en amont des N appareils de protection, et un détecteur de tension aval disposé en aval de chacun des N appareils de protection, alors l'on peut avantageusement exploiter les données de tension fournies par lesdits détecteurs de tension pour disposer d'informations sur la présence ou l'absence de la tension commune en amont des N appareils de protection et sur la présence ou l'absence de la tension individuelle en aval de chacun des N appareils de protection, et l'on peut ainsi déterminer l'état individuel de chacun des N appareils de protection.

Si l'installation électrique comporte deux niveaux hiérarchiques de distribution, un premier niveau alimenté par un tableau électrique principal et un second niveau alimenté par un tableau électrique terminal, chaque niveau de distribution comportant au moins un appareil de protection électrique, ladite installation comportant un unique détecteur de tension amont disposé en amont dudit au moins un appareil de protection du premier niveau et un détecteur de tension aval disposé en aval dudit au moins un appareil de protection du second niveau, alors l'on peut exploiter les données de tension fournies par lesdits détecteurs de tension pour disposer d'informations sur la présence ou l'absence de la tension commune en amont dudit premier niveau et sur la présence ou l'absence de la tension en aval dudit second niveau, et l'on peut ainsi déterminer l'état individuel d'au moins une partie desdits appareils de protection.

Si ladite installation électrique comporte un nombre X de niveaux hiérarchiques de distribution, un premier niveau alimenté par un tableau électrique principal, un nombre X-2 de niveaux intermédiaires alimentés par des tableaux électriques divisionnaires, et un dernier niveau alimenté par un tableau électrique terminal, chaque niveau de distribution comportant au moins un appareil de protection électrique, ladite installation comportant un unique détecteur de tension amont disposé en amont dudit au moins un appareil de protection du premier niveau et un détecteur de tension aval disposé en aval dudit au moins un appareil de protection du dernier niveau, alors l'on peut exploiter les données de tension fournies par lesdits détecteurs de tension pour disposer d'informations sur la présence ou l'absence de la tension commune en amont dudit premier niveau et sur la présence ou l'absence de la tension en aval dudit dernier niveau, et l'on peut ainsi déterminer l'état individuel d'au moins une partie desdits appareils de protection.

L'on peut également dans ce type d'installation prévoir un détecteur de tension aval disposé en aval dudit au moins un appareil de protection de chaque niveau intermédiaire, permettant en outre d'exploiter les données de tension fournies par lesdits détecteurs de tension pour disposer d'informations sur la présence ou l'absence de la tension en aval dudit au moins un appareil de protection de chaque niveau intermédiaire, et l'on peut ainsi déterminer l'état individuel de chacun desdits appareils de protection desdits niveaux intermédiaires.

L'on peut choisir ledit détecteur de tension amont et ledit détecteur de tension aval parmi des capteurs de présence de tension et/ou des capteurs de mesure de tension, et l'on peut alors exploiter des images de la tension vues et/ou des valeurs de tension mesurées par lesdits détecteurs de tension. De préférence, l'on utilise comme détecteur de tension amont et/ou détecteur de tension aval des capteurs sans contact.

Selon le type de détecteur de tension, l'on peut exploiter une valeur de tension mesurée par ledit détecteur de tension correspondant, et l'on peut comparer ladite valeur de tension mesurée audit seuil de tension.

A cet effet, l'invention concerne un dispositif de détection tel que défini dans la revendication 10.

Si l'appareil de protection électrique comporte plusieurs pôles et l'installation comporte sur chacun des pôles un détecteur de tension amont et un détecteur de tension aval disposés respectivement en amont et en aval dudit appareil de protection, l'unité de traitement est avantageusement agencée pour exploiter les données de tension fournies par les détecteurs de tension pôle par pôle, et disposer d'informations sur la présence ou l'absence de tension en amont et sur la présence ou l'absence de tension en aval dudit appareil de protection, et le module de corrélation des données de tension est dans ce cas avantageusement agencé pour comparer les données de tension pôle par pôle et déterminer en outre si l'appareil de protection est dans un état ouvert incomplet.

Si l'installation électrique comporte un nombre N d'appareils de protection électrique, un unique détecteur de tension amont disposé en amont des N appareils de protection agencé pour fournir une tension commune auxdits appareils de protection, et un détecteur de tension aval disposé en aval de chacun des N appareils de protection, l'unité de traitement est avantageusement agencée pour exploiter les données de tension fournies par les détecteurs de tension, disposer d'informations sur la présence ou l'absence de la tension commune amont des N appareils de protection et sur la présence ou l'absence de la tension individuelle en aval de chacun des N appareils de protection, et le module de corrélation est dans ce cas avantageusement agencé pour déterminer l'état individuel de chacun des N appareils de protection.

Si l'installation électrique comporte deux niveaux hiérarchiques de distribution, un premier niveau alimenté par un tableau électrique principal et un second niveau alimenté par un tableau électrique terminal, chaque niveau de distribution comportant au moins un appareil de protection électrique, l'installation comportant un unique détecteur de tension amont disposé en amont dudit au moins un appareil de protection du premier niveau et un détecteur de tension aval disposé en aval dudit au moins un appareil de protection du second niveau, l'unité de traitement est avantageusement agencée pour exploiter les données de tension fournies par les détecteurs de tension, disposer d'informations sur la présence ou l'absence de la tension commune en amont dudit premier niveau et sur la présence ou l'absence de la tension en aval dudit second niveau, et le module de corrélation est dans ce cas avantageusement agencé pour déterminer l'état individuel d'au moins une partie desdits appareils de protection.

Si l'installation électrique comporte un nombre X de niveaux hiérarchiques de distribution, un premier niveau alimenté par un tableau électrique principal, un nombre X-2 de niveaux intermédiaires alimentés par des tableaux électriques divisionnaires, et un dernier niveau alimenté par un tableau électrique terminal, chaque niveau de distribution comportant au moins un appareil de protection électrique, l'installation comportant un unique détecteur de tension amont disposé en amont dudit au moins un appareil de protection du premier niveau et un détecteur de tension aval disposé en aval dudit au moins un appareil de protection du dernier niveau, l'unité de traitement est avantageusement agencée pour exploiter les données de tension fournies par les détecteurs de tension, disposer d'informations sur la présence ou l'absence de la tension commune en amont dudit premier niveau et sur la présence ou l'absence de la tension en aval dudit dernier niveau, et le module de corrélation est dans ce cas avantageusement agencé pour déterminer l'état individuel d'au moins une partie desdits appareils de protection.

Si l'installation comporte en outre un détecteur de tension aval disposé en aval dudit au moins un appareil de protection du chaque niveau intermédiaire, l'unité de traitement est avantageusement agencée pour exploiter en outre les données de tension fournies par les détecteurs de tension, disposer d'informations sur la présence ou l'absence de la tension en aval dudit au moins un appareil de protection de chaque niveau intermédiaire, et le module de corrélation est dans ce cas avantageusement agencé pour déterminer l'état individuel de chacun des appareils de protection de chacun des niveaux intermédiaires.

Selon les variantes de réalisation dudit dispositif de détection, ledit détecteur de tension amont et ledit détecteur de tension aval peuvent être des capteurs de présence de tension et/ou des capteurs de mesure de tension, et ladite unité de traitement est dans ce cas agencée pour exploiter des images de la tension vues et/ou des valeurs de tension mesurées par lesdits détecteurs de tension. De manière préférée, ledit détecteur de tension amont et/ou ledit détecteur de tension aval sont des capteurs sans contact.

Dans une variante de réalisation avantageuse, ladite unité de traitement peut comporter en outre un module de synchronisation agencé pour caler la fréquence d'échantillonnage desdites données de tension et de courant fournies par lesdits détecteurs de tension et par ledit dispositif de mesure du courant.

Ainsi, ce nouveau procédé de détection et le dispositif de détection qui permet de le mettre en œuvre présentent des avantages liés à l'absence de câblage des contacts auxiliaires ou d'appareils dédiés par rapport aux solutions de l'état de la technique, qui sont notamment :
- une diminution des coûts (plus de contact auxiliaire, plus de câblage)
- une réduction de l'espace nécessaire dans le tableau électrique
- une minimisation des erreurs de raccordement
- une interprétation de la cause du déclenchement grâce à l'analyse directe des courants
- une augmentation de la précision et de la fiabilité des informations détectées due à la suppression du câblage.

De plus, la solution de l'invention est une solution globale qui permet un diagnostic complet de l'installation, précis et en temps réel, capable de cartographier l'installation notamment lorsqu'elle comporte plusieurs niveaux de distribution, pour pouvoir intervenir en toute sécurité et de façon très ciblée, d'où un gain de temps et d'efficacité.

### Description sommaire des dessins :

La présente invention et ses avantages apparaîtront mieux dans la description suivante d'un mode de réalisation donné à titre d'exemple non limitatif, en référence aux dessins annexés, dans lesquels:
- la figure 1 est un schéma d'une installation électrique qui illustre le procédé de détection de l'état d'un appareil de protection électrique de l'art antérieur,
- la figure 2 est un schéma d'une installation électrique qui illustre le procédé de détection de l'état d'un appareil de protection électrique selon l'invention,
- la figure 3 est un schéma fonctionnel du dispositif de détection de l'invention,
- la figure 4 est un logigramme illustrant la logique de détermination de l'état ouvert ou fermé d'un pôle d'un appareil de protection,
- la figure 5 est une étape du logigramme de la figure 4 permettant de déterminer la présence ou l'absence de tension à partir d'une image de la tension,
- la figure 6 est une étape du logigramme de la figure 4 permettant de déterminer la présence ou l'absence de tension à partir d'une valeur de tension mesurée,
- la figure 7 est un logigramme illustrant la logique d'identification de la cause de l'état ouvert d'un appareil de protection, et
- la figure 8 est un schéma d'une installation électrique à plusieurs niveaux de distribution qui illustre le procédé de détection de l'état d'un appareil de protection électrique selon l'invention.

### Illustrations de l'invention et différentes manières de la réaliser :

Dans les exemples de réalisation illustrés, les éléments ou parties identiques portent les mêmes numéros de référence.

Le procédé de détection de l'état ouvert ou fermé d'un appareil de protection selon l'invention se différencie de celui de l'état de l'art par l'absence de contacts auxiliaires et du câblage associé auxdits contacts auxiliaires.

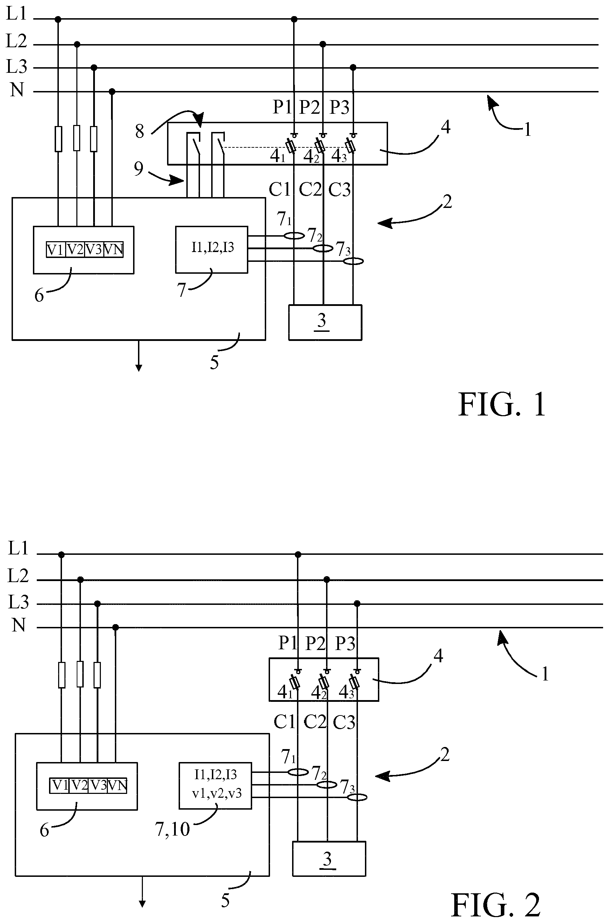

Pour mieux comprendre l'intérêt de la présente invention, la figure 1 illustre schématiquement une installation électrique de l'état de l'art comportant un réseau d'alimentation électrique 1 pourvu de trois phases L1, L2, L3 et d'un neutre N, duquel part une branche de réseau 2 pour alimenter une charge 3 consommatrice d'énergie, via un appareil de protection électrique 4 tel qu'un disjoncteur, sans que cet exemple ne soit limitatif. La charge 3 est triphasée et alimentée par trois conducteurs C1, C2, C3 en dérivation des phases L1, L2, L3 du réseau 1. L'appareil de protection 4 comporte dans ce cas trois pôles P1, P2, P3, chacun pourvu d'un contact mobile 4₁, 4₂, 4₃. L'installation électrique comporte une unité de traitement 5 agencée pour faire par exemple du comptage d'énergie afin de déterminer la consommation de la charge 3 et/ou la mesure de paramètres électriques (courant, puissances, harmoniques, etc...). Cette unité de traitement 5 peut être équipée d'un module d'affichage et/ou d'un module de communication pourvu d'une connexion filaire ou non vers une centrale de supervision (non représentée sur cette figure) permettant l'exploitation des données traitées. Elle comporte notamment un détecteur de tension 6 raccordé au réseau 1 en amont de la branche de réseau 2, pour détecter la tension V1, V2, V3 sur les trois phases L1, L2, L3 et la tension VN sur le neutre N alimentant la charge 3. Elle comporte également un dispositif de mesure du courant 7 raccordé à trois capteurs de courant 7₁, 7₂, 7₃, chacun installé sur un des conducteurs C1, C2, C3 de la branche de réseau 2, en aval de l'appareil de protection 4 et en amont de la charge 3, pour détecter le courant I1, I2, I3 traversant ladite charge 3. Pour effectuer du comptage d'énergie dans ladite installation électrique représentée, la détection de tension et la détection de courant correspondent à des mesures réelles et précises de la valeur de la tension V et du courant I alimentant la charge 3. Bien entendu, cet exemple n'est pas limitatif.

Conformément au procédé de détection connu, l'appareil de protection 4 comporte en outre des contacts auxiliaires 8, notamment deux contacts auxiliaires 8, liés mécaniquement aux contacts mobiles 4₁, 4₂, 4₃ de l'appareil de protection 4 et raccordés électriquement à l'unité de traitement 5 via un câblage 9. Un des contacts auxiliaires 8 est représentatif de l'état ouvert ou fermé des contacts mobiles de l'appareil de protection 4 et l'autre contact auxiliaire 8 est représentatif de l'état de déclenchement de l'appareil de protection 4. A cet effet, l'unité de traitement 5 comporte une identification de l'état des contacts auxiliaires 8 permettant de fournir à l'opérateur une information à la fois sur l'état ouvert ou fermé dudit appareil de protection 4 et sur son éventuel déclenchement. L'unité de traitement 5 peut également être capable d'identifier la cause supposée du déclenchement de l'appareil de protection 4 en fonction de ses caractéristiques de déclenchement et de la valeur du courant au moment dudit déclenchement.

La figure 2 illustre schématiquement une installation électrique selon l'invention comportant la même configuration que celle décrite en référence à la figure 1, à la différence que son appareil de protection 4 ne comporte pas de contacts auxiliaires ni de câblage de ces contacts à l'unité de traitement 5, ce qui simplifie considérablement le câblage de l'installation, réduit l'encombrement de l'appareil et le volume occupé dans l'armoire électrique. Elle comporte en outre un détecteur de tension 10 pour détecter la tension v1, v2, v3 sur les conducteurs C1, C2, C3 de la branche du réseau 2 alimentant la charge 3 en aval de l'appareil de protection 4. Dans l'exemple illustré, le détecteur de tension 10 est intégré dans le dispositif de mesure du courant 7. Cet exemple n'est pas limitatif, puisqu'il pourrait être dissocié.

Pour mettre en œuvre le procédé de détection selon l'invention, il est nécessaire de disposer des informations sur la présence de la tension amont V et de la tension aval v de l'appareil de protection 4. La mesure du courant I n'est pas nécessaire mais elle permet d'obtenir des informations additionnelles, comme expliqué plus loin. Ces informations sont exploitées par l'unité de traitement 5, qui comporte notamment des circuits de conditionnement analogique, des circuits de conversion analogique/numérique et une unité de calcul pilotée par un logiciel adapté.

L'information sur la présence de la tension amont V et de la tension aval v de l'appareil de protection 4 peut être obtenue par une mesure, mais une valeur approximative ou représentative, donnée par exemple par une estimation ou une image, peut être suffisante, comme expliqué plus loin. On utilise à cet effet les signaux de tension délivrés par les détecteurs de tension 6 et 10 de la figure 2 déjà existants dans l'installation électrique, sans avoir besoin d'ajouter de matériel spécifique, ni de câblage additionnel.

La tension amont V, ou tension de référence, peut être mesurée ou détectée soit directement en amont de l'appareil de protection 4, soit à distance au niveau du tableau principal par un détecteur de tension 6 (voir figure 2).

La tension aval v associée ou non au dispositif de mesure du courant 7, peut être mesurée ou détectée, avec ou sans contact, via un détecteur de tension 10 (voir figure 2). Il peut par exemple comporter une électrode placée à l'intérieur du dispositif de mesure du courant 7 qui fournit une image de la tension très imprécise en amplitude mais relativement précise en phase.

Ces exemples ne sont pas limitatifs. En effet, en fonction du type de détecteurs de tension 6, 10 prévus dans l'installation électrique, le signal de tension obtenu peut être soit une image de la tension amont V et/ou de la tension aval v, qui consiste en un signal de tension de même forme sinusoïdale que la tension V, v du réseau mais n'ayant pas la même valeur de tension ou une valeur de tension imprécise, soit une mesure précise de la tension V, v. Si l'un et/ou l'autre de ces détecteur 6, 10 est constitué d'une prise de tension sous la forme d'un piquage sur chacune des phases L1, L2, L3 du réseau 1 et/ou sur chacun des conducteurs C1, C2, C3 de la branche du réseau 2, ou d'un capteur de tension sans contact tel qu'un couplage capacitif ou une mesure de champ électrique, alors le signal de tension obtenu est une image représentative de la tension V, v. Cette image de la tension peut être très imprécise en amplitude étant donné qu'elle ne sert pas à mesurer la tension réelle V, v, mais sa forme est proche du signal de tension réel et son décalage temporel avec le signal de tension réel est relativement faible, de l'ordre de quelques degrés de déphasage par rapport à la fréquence du réseau égale par exemple à 50Hz. Si l'un et/ou l'autre de ces détecteurs 6, 10 est constitué d'un capteur résistif, avec ou sans perforation de l'isolant du conducteur sur lequel est couplé ledit capteur, alors le signal de tension délivré est une mesure précise de la tension V, v entre une ou des phases L1, L2, L3 et un potentiel de référence, ou entre un ou des conducteurs C1, C2, C3 et un potentiel de référence, le potentiel de référence pouvant être par exemple la terre ou le neutre N. On privilégiera une solution de détection de tension sans contact qui a l'avantage de ne nécessiter aucun câblage, d'être simple à mettre en œuvre, peu coûteuse et très facile à déployer notamment dans une installation à plusieurs niveaux de distribution. Cette détection de tension sans contact peut être prévue aussi bien en amont ou en aval, ou encore en amont et en aval de l'appareil de protection 4. Une solution préférée peut être une mesure de tension en amont et une détection de tension sans contact en aval.

### Détermination de l'état ouvert ou fermé d'un appareil de protection

En utilisant l'information sur la présence de la tension amont V et sur la présence de la tension aval v de l'appareil de protection 4, on peut identifier les quatre états suivants de l'appareil de protection 4 :
- Tension amont V présente et tension aval v présente :
   ⇒ L'appareil de protection 4 est dans un état fermé.
- Tension amont V présente et tension aval v absente :
   ⇒ L'appareil de protection 4 est dans un état ouvert.
- Tension amont V absente et tension aval v présente :
   ⇒ L'appareil de protection 4 est dans un état ouvert et il y a réalimentation par la charge 3.
- Tension amont V absente et tension aval v absente :
   ⇒ L'appareil de protection 4 est dans un état indéterminé.

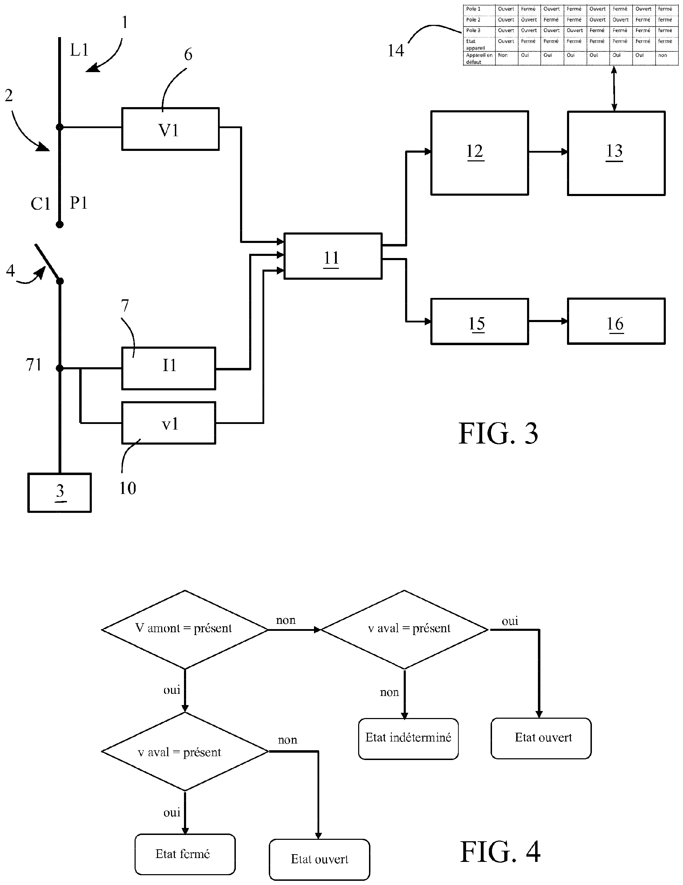

La logique du traitement de l'information relative à la présente ou l'absence des tensions en amont V et en aval v de l'appareil de protection 4 est illustrée par le logigramme de la figure 4. Cette logique s'applique bien évidemment à chaque pôle P1, P2, P3 dudit appareil de protection 4 et ce quel que soit le nombre de pôles.

Dans le cas d'un appareil de protection 4 polyphasé, par exemple triphasé comme illustré, et si l'on compare les tensions en amont V1, V2, V3 avec les tensions en aval v1, v2, v3 sur chacun des conducteurs et donc sur chacun des pôles P1, P2, P3, on peut identifier en outre l'état suivant de l'appareil de protection 4 :
- Tension amont V1, V2, V3 présente et tension aval v1, v2, v3 absente sur certains pôles P1, P2 et/ou P3 :
   ⇒ L'appareil de protection 4 est dans un état ouvert incomplet - ce qui peut être le cas pour un appareil de protection de type fusible ou interrupteur-fusible, mais aussi dans le cas d'une casse d'un appareil de type interrupteur ou disjoncteur.

L'information de la présence ou de l'absence de tension V, v peut être conditionnée à un seuil de tension en dessous duquel la tension est considérée comme absente.

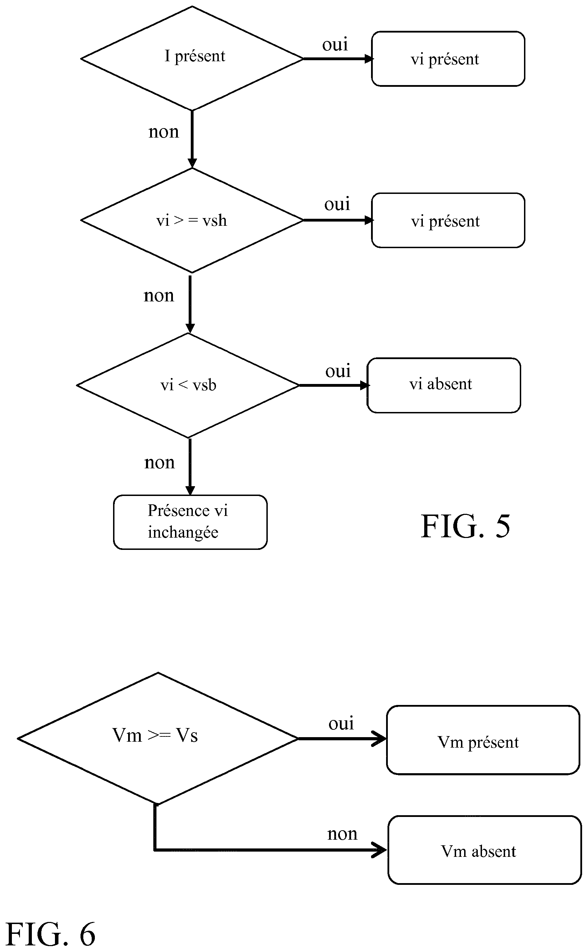

Pour déterminer si la tension amont V est présente ou absente, on utilise dans ce cas une mesure de tension obtenue par le détecteur de tension 6. On compare alors la valeur de tension mesurée Vm à une valeur de seuil Vs. Si la valeur de tension mesurée Vm est supérieure ou égale à la valeur de seuil Vs, alors la tension Vm est considérée comme présente et égale à 1, sinon elle est considérée comme absente et égale à 0, dans un système binaire. La valeur de seuil Vs peut être par exemple égale à 50V, sans que cette valeur ne soit limitative. Le logigramme de la figure 6 illustre cette logique de traitement. Bien entendu, cette logique de traitement s'applique de manière similaire pour déterminer si la tension aval v est présente ou absente, si l'on dispose d'une mesure de tension obtenue par le détecteur de tension 10.

Pour déterminer si la tension aval v est présente ou absente, on utilise la détection de tension obtenue par le détecteur de tension 10. S'il s'agit d'une détection par couplage capacitif sans contact et que l'on connait le niveau minimum de capacité de couplage, pouvant aller d'une fraction de picofarads à quelques dizaines de picofarads, on peut alors fixer un seuil en dessous duquel la tension aval v est considérée comme absente. Si on dispose en plus de l'information de présence de courant alimentant la charge 3 obtenue par le dispositif de mesure du courant 7, on peut estimer la valeur de la capacité de couplage lorsque le courant 1 est présent. Le courant I est considéré comme présent s'il est dans une zone de fonctionnement normal, c'est-à-dire ni trop faible pour ne pas être confondu avec du bruit, ni trop fort pour ne pas tenter une calibration dans une situation de court-circuit qui pourrait provoquer une baisse significative de la tension. Lorsque le courant I est dans cette zone de fonctionnement dite normale, par exemple entre 10% et 100% du courant I nominal, cela signifie que l'appareil de protection 4 est en position fermée et que la tension v présente sur le conducteur C1, C2, C3 en aval de l'appareil de protection 4 est très proche du niveau de tension V en amont. Dans ces conditions, on peut établir une relation entre le niveau de sortie Vdet du détecteur de tension 10 sans contact et le niveau de tension V réel présent en amont. Par exemple, si la tension amont mesurée est de V=230V, que le courant I est dans la zone de fonctionnement normal, et que le niveau de sortie du détecteur de tension 10 est de Vdet=23mV, alors on aura la relation suivante : v=Vdet^{∗}230V/23mV=Vdet^{∗}1000. Si on obtient Vdet=10mV alors on pourra en déduire que la tension aval est de v=100V. On peut donc mémoriser ce niveau de sortie Vdet du détecteur de tension 10 correspondant à un état fermé et fixer un seuil de tension Vs adapté, par exemple 50% (ou tout autre pourcentage) du niveau de sortie Vdet mémorisé pour décréter une absence de la tension aval v. De cette manière, on fiabilise l'information de présence/absence de la tension aval v. En effet, sans cette opération de calibration en ligne, la variation de la capacité de couplage du détecteur de tension 10 sans contact est telle que ces 10mV pourraient tout aussi bien correspondre à 50V qu'à 200V et rendre ainsi la détection de présence ou d'absence de tension aval v très aléatoire. En résumé, on exploite avantageusement la valeur de courant I mesurée par le dispositif de mesure du courant 7 comme un moyen de calibrage pour déterminer la valeur normale ou nominale de la tension V, v en amont et/ou en aval de l'appareil de protection 4 et fixer à partir de cette valeur normale ou nominale de la tension un seuil de tension Vs en dessous duquel la tension amont V et/ou la tension aval v est considérée comme absente. On appelle « valeur normale de la tension », une valeur de tension proche de la valeur nominale de la tension. Ainsi, l'expression « valeur nominale de la tension » utilisée dans la présente demande ne doit pas être interprétée dans un sens restrictif, car elle désigne indifféremment les deux notions, à savoir une valeur « normale » ou une valeur « nominale » de la tension.

La figure 5 illustre ce cas de figure sous la forme d'un logigramme qui prévoit deux niveaux de seuil de tension, à savoir une valeur de seuil haut vsh correspondant à une fonction de la tension nominale et une valeur de seuil bas vsb égale par exemple à 80% du seuil haut vsh. Ces exemples de valeur de seuil ne sont bien entendu pas limitatifs. Dans ce cas, on compare la valeur de l'image de tension vi à une valeur de seuil vs. En présence d'un courant I alimentant une charge 3, la tension vi est présente. En l'absence d'un courant alimentant une charge 3, et si la valeur de l'image de tension vi est supérieure ou égale à la valeur de seuil haut vsh, alors la tension vi est considérée comme présente et égale à 1, sinon on la compare à la valeur de seuil bas vsb. Si la valeur de l'image de tension vi est inférieure à la valeur de seuil bas vsb, alors la tension vi est considérée comme absente et égale à 0, sinon la tension vi est considérée comme présente et égale à 1 dans un système binaire. Bien entendu, cette logique de traitement s'applique de manière similaire pour déterminer si la tension amont V est présente ou absente, si l'on ne dispose que d'une détection de tension obtenue par le détecteur de tension 6 et non d'une mesure de tension.

Dans une seconde variante, et en fonction du type d'appareil de protection 4, on pourrait émuler la courbe de déclenchement magnétothermique dudit appareil de protection 4 et déterminer la cause de l'ouverture, surcharge ou court-circuit, en fonction de la zone de la courbe dans laquelle on se trouve au moment du déclenchement de l'appareil de protection 4. Par exemple, si le courant I au moment de l'ouverture est compris entre un premier seuil SI et un deuxième seuil S2 supérieur au premier seuil S1, alors on considère qu'il y a surcharge, si ledit courant I est supérieur à S2, alors on considère il y a court-circuit. Si le courant I au moment de l'ouverture est inférieur à S1, alors on considère qu'on est a priori dans le cas d'une ouverture intentionnelle (manuelle ou commandée). Ces seuils sont bien entendu à régler en fonction de la connaissance que l'on a de l'appareil de protection 4. Si l'on est en présence d'un appareil de protection différentielle, il faut disposer d'une mesure dudit courant différentiel pour être capable de discriminer une ouverture intentionnelle d'une ouverture sur défaut.

### Détermination de la cause de l'état ouvert d'un appareil de protection

La mesure additionnelle du courant I permet en plus de déterminer le type d'ouverture et la cause du déclenchement de l'appareil de protection 4 selon la valeur du courant mesuré :
- Ouverture en présence d'un courant I inférieur à un premier seuil correspondant par exemple 10% de I nominal (In) :
   ⇒ Ouverture de l'appareil de protection 4 volontaire par une commande manuelle ou à distance, hors charge
- Ouverture en présence d'un courant I inférieur ou égal à un deuxième seuil correspondant par exemple à 110% de I nominal (In) :
   ⇒ Ouverture de l'appareil de protection 4 volontaire par une commande manuelle ou à distance, en charge
- Ouverture en présence d'un courant I supérieur à un troisième seuil correspondant par exemple à 110% de I nominal (In) :
   ⇒ Ouverture de l'appareil de protection 4 sur un courant de surcharge
- Ouverture en présence d'un courant supérieur ou égal à un quatrième seuil correspondant par exemple à 300% de I nominal (In) :
   ⇒ Ouverture de l'appareil de protection 4 sur un courant de court-circuit.

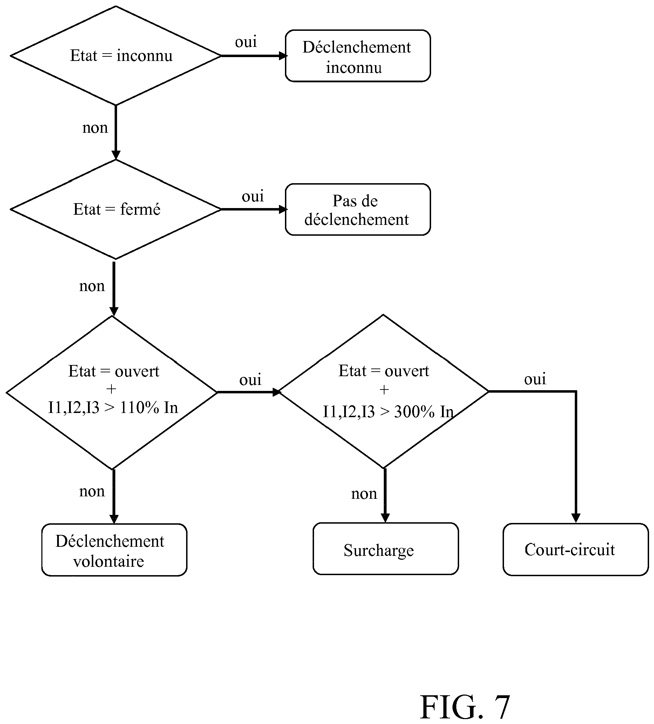

La logique de traitement est représentée par un logigramme en figure 7 en fonction de l'état de l'appareil de protection 4 déterminé lors de la première phase de traitement représentée par le logigramme de la figure 4. Seul l'état ouvert de l'appareil de protection 4 nécessite d'avoir une information sur la cause de son déclenchement. C'est pourquoi les deux premiers niveaux du logigramme de la figure 7 ne donnent pas lieu à la détermination d'une cause d'une part si l'appareil de protection 4 est dans un état indéterminé, et d'autre part si l'appareil de protection 4 est dans un état fermé. Par contre, si l'appareil de protection 4 est à l'état ouvert, il convient de vérifier le niveau de l'intensité I circulant dans les conducteurs C1, C2, C3 alimentant la charge 3 via le dispositif de mesure du courant 7 au moment de l'ouverture. Si la valeur mesurée du courant I1, I2, I3 est supérieure au seuil de surcharge par exemple égal à 110% de I nominal (In), alors on vérifie si cette valeur est également supérieure au seuil de court-circuit par exemple à 300% de I nominal (In). Si la réponse est oui, alors il y a déclenchement et la cause du déclenchement de l'appareil de protection 4 est un court-circuit. Si la réponse est non, alors il y a déclenchement et la cause du déclenchement de l'appareil de protection 4 est une surcharge. Si la valeur mesurée du courant I1, 12, 13 est inférieure à 110% de I nominal (In), alors il n'y a pas déclenchement et la cause de l'ouverture de l'appareil de protection 4 est une commande volontaire et non accidentelle.

### Implémentation du procédé de détection de l'invention

La figure 3 permet d'illustrer le schéma fonctionnel du dispositif de détection permettant la mise en œuvre du procédé de détection selon l'invention. Il représente les modules fonctionnels mis en œuvre pour détecter l'état ouvert ou fermé d'un appareil de protection 4, ainsi que la cause de son ouverture. L'appareil de protection 4 est symbolisé par un seul pôle P1 monté sur une seule phase L1 et un seul conducteur C1 entre un réseau 1 et une charge 3.

Dans une première phase de traitement, les signaux de tension amont V1 et de tension aval v1 délivrés par les détecteurs de tension 6 et 10 sont envoyés dans un module de détermination de la présence de tension 12 permettant, par un traitement binaire desdits signaux, réalisé de préférence par une fonction logicielle, sans que cet exemple ne soit limitatif étant donné que tout autre système de comparaison analogique ou de logique câblée pourrait convenir, d'identifier si chacune des tensions V1 et v1 est présente ou absente. Puis ce résultat binaire est envoyé dans un module de corrélation 13 qui, en fonction d'une table de vérité 14 correspondant au type d'appareil de protection 4 concerné, délivre une information relative à l'état dudit appareil : ouvert, fermé, en défaut. Le type d'appareil de protection 4 est un paramètre fourni par l'utilisateur et entré dans le logiciel adapté contenu dans l'unité de traitement 5. Une table de vérité 14 correspondant à chacun des types d'appareil de protection 4 connus peut être disponible dans ledit logiciel adapté.

Dans une seconde phase de traitement, qui peut se dérouler en parallèle et simultanément à la première phase de traitement, la mesure de courant I1 délivrée par le dispositif de mesure du courant 7 est envoyée dans un module de calcul 15 permettant de délivrer une valeur efficace du courant I1, qui est ensuite envoyée dans un module de comparaison 16 permettant de comparer la valeur efficace du courant Il à différents seuils de courant et de déterminer si l'ouverture de l'appareil de protection 4 est normale ou accidentelle suite à une surcharge ou à un court-circuit. Ces modules de calcul 15 et de comparaison 16 sont de préférence des fonctions logicielles, sans que cet exemple ne soit limitatif étant donné que tout autre système de comparaison analogique ou de logique câblée pourrait convenir. Le dispositif de mesure du courant 7 peut être constitué par tout capteur de courant connu et notamment celui décrit dans la publication WO 2015/150671 A1 du demandeur.

Les signaux de tension V1, v1 et de courant I1 délivrés par les détecteurs de tension 6, 10 et le dispositif de mesure du courant 7 peuvent, préalablement auxdites phases de traitement, passés par un module de synchronisation 11 permettant de caler en fréquence l'échantillonnage desdits signaux pour faciliter leur analyse. Toute technique de synchronisation d'échantillons de mesure peut convenir, et notamment celle décrite dans la publication WO 2015/150670 A1 du demandeur qui permet une synchronisation des échantillons de tension et de courant mesurés de l'ordre de 1µs, c'est-à-dire garantissant une excellente qualité métrologique malgré la présence éventuelle d'harmoniques, ainsi qu'une mutualisation du détecteur de tension 6 en amont de l'installation.

De manière optionnelle, l'unité de traitement 5 du dispositif de détection peut être complétée par un module de corrélation additionnel (non représenté) permettant de corriger automatiquement les éventuelles erreurs de câblage dans le cas de détecteurs de tension 6, 10 avec contact, donc câblés, conformément à la solution décrite dans la publication WO 2015/150671 A1 du demandeur.

Les tables de vérité 14 sont des tableaux à deux entrées qui en fonction de l'état ouvert ou fermé de chaque pôle P1, P2, P3 de l'appareil de protection 4 concerné, permettent de déterminer si l'appareil de protection 4 est à l'état ouvert ou fermé et si l'appareil de protection 4 est ou non en défaut correspondant à un état ni complètement ouvert ni complètement fermé. Les tableaux ci-dessus illustrent différentes tables de vérité 14 en fonction du type d'appareil de protection 4 et du nombre de pôles de cet appareil.

Disjoncteur à un pôle :

| Pole | Ouvert | Fermé |
|---|---|---|
| Etat appareil de protection | Ouvert | Fermé |

Disjoncteur à 2 ou 3 pôles :

| | | | | | | | | |
|---|---|---|---|---|---|---|---|---|
| Pole 1 | Ouvert | Fermé | Ouvert | Fermé | Ouvert | Fermé | Ouvert | fermé |
| Pole 2 | Ouvert | Ouvert | Fermé | Fermé | Ouvert | Ouvert | Fermé | fermé |
| Pole 3 | Ouvert | Ouvert | Ouvert | Ouvert | Fermé | Fermé | Fermé | fermé |
| Etat appareil | Ouvert | Fermé | Fermé | Fermé | Fermé | Fermé | Fermé | fermé |
| Appareil en défaut | Non | Oui | Oui | Oui | Oui | Oui | Oui | non |

Interrupteur-fusible à un pôle :

| Pole | Ouvert | Fermé |
|---|---|---|
| Etat appareil de protection | Ouvert | Fermé |

Interrupteur-fusible à 2 ou 3 pôles :

| | | | | | | | | |
|---|---|---|---|---|---|---|---|---|
| Pole 1 | Ouvert | Fermé | Ouvert | Fermé | Ouvert | Fermé | Ouvert | fermé |
| Pole 2 | Ouvert | Ouvert | Fermé | Fermé | Ouvert | Ouvert | Fermé | fermé |
| Pole 3 | Ouvert | Ouvert | Ouvert | Ouvert | Fermé | Fermé | Fermé | fermé |
| Etat appareil | Ouvert | Fermé | Fermé | Fermé | Fermé | Fermé | Fermé | fermé |
| Appareil en défaut | Oui | Oui | Oui | Oui | Oui | Oui | Oui | non |

### Variante de réalisation de l'invention

Le procédé de détection selon l'invention peut être étendu à une installation électrique comportant plusieurs branches 2 en dérivation sur le réseau d'alimentation électrique 1, chaque branche 2 comportant un appareil de protection 4 à surveiller, ou plusieurs niveaux hiérarchiques de distribution, comportant des appareils de protection 4 à chaque niveau, par exemple localisés dans un tableau principal pour le premier niveau, dans des tableaux divisionnaires pour les niveaux intermédiaires, et dans des tableaux terminaux pour les derniers niveaux.

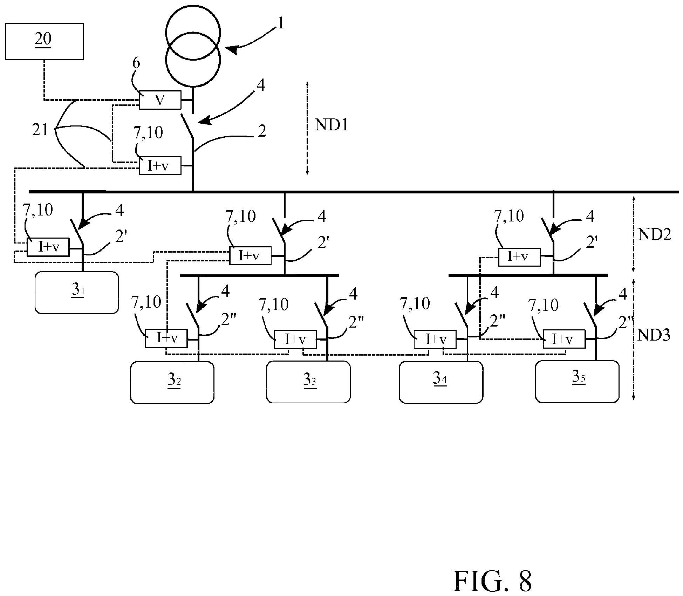

La figure 8 permet d'illustrer schématiquement un exemple d'installation électrique comportant trois niveaux de distribution :
- Un premier niveau de distribution ND1, en tête d'installation, comportant une branche principale 2 alimentée par le réseau 1 symbolisé par un transformateur de courant via un tableau principal (non représenté), et pourvue d'un appareil de protection 4, d'un détecteur de tension amont 6 et d'un dispositif de mesure du courant 7 intégrant un détecteur de tension aval 10,
- Un deuxième niveau de distribution ND2, en aval du premier niveau ND1, comportant trois branches divisionnaires intermédiaires 2' issues de la branche principale 2 via un tableau divisionnaire (non représenté), et pourvues chacune d'un appareil de protection 4, d'un détecteur de tension amont 6 et d'un dispositif de mesure du courant 7 intégrant un détecteur de tension aval 10, seule une des branches divisionnaires 2' alimente une charge 3₁,
- Un troisième et dernier niveau de distribution ND3, en aval du deuxième niveau ND2, comportant quatre branches divisionnaires terminales 2" issues de deux des branches divisionnaires intermédiaires 2' via un tableau terminal (non représenté), pourvues chacune d'un appareil de protection 4, d'un détecteur de tension amont 6 et d'un dispositif de mesure du courant 7 intégrant un détecteur de tension aval 10, et alimentant chacune charge 3₂, 3₃, 3₄ et 3₅.

Dans cette configuration d'installation, on prévoit une seule mesure ou une seule détection de la tension amont V via un détecteur de tension 6 unique et commun à toute l'installation et prévu au niveau du tableau électrique principal en tête de l'installation. On mutualise ainsi avantageusement la détection de la tension amont V, conformément à la solution décrite dans la publication WO 2015/150670 A1 du demandeur, que l'on transmet via un bus de communication 21 d'une part à une centrale de supervision 20 et d'autre part aux différentes unités de traitement 5 (confondues avec le dispositif de mesure de courant 7 et le détecteur de tension aval 10) dans les différentes branches 2, 2', 2" et aux différents niveaux de distribution ND1, ND2, ND3. On prévoit par ailleurs une mesure ou une détection de la tension aval v en aval de chaque appareil de protection 4 protégeant les charges 3₁, 3₂, 3₃, 3₄ et 35 dans un tableau divisionnaire ou un tableau terminal selon la position de la charge dans les niveaux de distribution ND2, ND3.

En utilisant l'information commune de la présence de la tension amont V dans le tableau principal et de la présence de la tension aval v de l'appareil de protection 4 de la charge 3₁, 3₂, 3₃, 3₄ et 3₅ considérée, il est possible de déterminer les quatre états suivants des appareils de protection 4 connectés en série :
- Tension amont V dans le tableau principal présente et tension aval v présente:
   ⇒ Tous les appareils de protection 4 entre le tableau principal et la charge considérée sont fermés
- Tension amont V dans le tableau principal présente et tension aval v absente :
   ⇒ Un ou plusieurs appareils de protection 4 entre le tableau principal et la charge considérée sont ouverts
- Tension amont V dans le tableau principal absente et tension aval v présente :
   ⇒ Un ou plusieurs appareils de protection 4 entre le tableau principal et la charge considérée sont ouverts et il y a réalimentation par ladite charge
- Tension amont V dans le tableau principal absente et tension aval v absente :
   ⇒ L'état des appareils de protection 4 entre le tableau principal et la charge considérée sont indéterminés.

Si on dispose à chaque niveau de distribution ND1, ND2, ND3 de l'installation, des détecteurs de tension 10, la détermination exacte de l'endroit où l'appareil de protection 4 est à l'état ouvert se basera sur les informations de présence de tension à chaque niveau conformément au procédé décrit précédemment.

Si l'information de présence de tension n'est pas prévue à chaque niveau de distribution, mais si le courant traversant l'appareil de protection 4 amont est connu, on peut affiner l'endroit où l'appareil de protection 4 est à l'état ouvert :
- Si ce courant est non nul, c'est l'appareil de protection 4 aval qui est à l'état ouvert, et
- Si ce courant est nul, l'endroit où l'appareil de protection 4 est à l'état ouvert est indéterminé.

Il ressort clairement de cette description, que le procédé et le dispositif de détection selon l'invention permettent de fournir un diagnostic complet, précis et en temps réel du fonctionnement de l'installation électrique, de dresser une cartographie de cette installation notamment lorsqu'elle comporte plusieurs niveaux de distribution, d'identifier le ou les appareils de protection 4 en défaut, et d'intervenir de façon très cibler. En outre, la détection de tension sans contact favorise le déploiement de l'invention dans tout type d'installations y compris celles à multi-niveaux en diminuant drastiquement les erreurs de câblage et l'encombrement correspondant.

La présente invention n'est pas limitée aux exemples de réalisation décrits mais s'étend à toute modification et variante évidentes pour un homme du métier.

## Revendications

1. Procédé de détection de l'état ouvert ou fermé d'un appareil de protection électrique (4) dans une installation électrique pour alimenter une charge (3) consommatrice d'énergie, ladite installation comportant un détecteur de tension amont (6) et un détecteur de tension aval (10) disposés respectivement en amont et en aval dudit appareil de protection (4), et un dispositif de mesure du courant (7) disposé en aval dudit au moins un appareil de protection (4) agencé pour détecter le courant (I) traversant ladite charge (3), procédé dans lequel l'on exploite les données de tension (V, v) fournies par lesdits détecteurs de tension (6, 10) pour disposer d'informations sur la présence ou l'absence de la tension (V) en amont et sur la présence ou l'absence de la tension (v) en aval dudit appareil de protection (4), et pour identifier si chacune des tensions (V, v) est présente ou absente, l'on fixe un seuil de tension (Vs) en dessous duquel l'on considère la tension (V, v) en amont et/ou en aval dudit appareil de protection (4) comme absente, **caractérisé en ce que** l'on exploite une valeur de courant (I) mesurée par ledit dispositif de mesure du courant (7) pour déterminer par calibration une valeur nominale de la tension (V, v) en amont et/ou en aval dudit appareil de protection (4) et fixer à partir de cette valeur nominale de la tension ledit seuil de tension (Vs), **en ce que** l'on établit une corrélation entre lesdites données de tension (V, v) et une table de vérité (14) correspondant au type d'appareil de protection (4) concerné pour déterminer, en fonction de la présence ou de l'absence desdites tensions (V, v), si ledit appareil de protection (4) est dans un état ouvert, dans un état fermé, dans un état anormal ou dans un état indéterminé dans lequel la tension (V) en amont et la tension (v) en aval sont absentes, et **en ce qu'**en outre l'on exploite la valeur de courant mesurée par ledit dispositif de mesure du courant (7) pour déterminer la cause de l'ouverture dudit appareil de protection (4) entre une ouverture volontaire et une ouverture accidentelle due à une surcharge ou à un court-circuit.

2. Procédé selon la revendication 1, dans lequel ledit appareil de protection électrique (4) comporte plusieurs pôles (P1, P2, P3) et ladite installation comporte sur chacun des pôles (P1, P2, P3) un détecteur de tension amont (6) et un détecteur de tension aval (10) disposés respectivement en amont et en aval dudit appareil de protection (4), **caractérisé en ce que** l'on exploite les données de tension (V, v) fournies par lesdits détecteurs de tension (6, 10), pôle par pôle (P1, P2, P3), pour disposer d'informations sur la présence ou l'absence de la tension (V) en amont et sur la présence ou l'absence de la tension (v) en aval dudit appareil de protection (4), **en ce que** l'on compare les données de tension (V, v) pôle par pôle, et **en ce que** l'on détermine en outre si ledit appareil de protection (4) est dans un état ouvert incomplet dans lequel la tension (V) en amont est présente sur tous les pôles (P1, P2, P3) et la tension (v) en aval est absente sur certains pôles.

3. Procédé selon l'une quelconque des revendications 1 et 2, dans lequel ladite installation électrique comporte un nombre N d'appareils de protection électrique (4), un unique détecteur de tension amont (6) disposé en amont des N appareils de protection (4) pour fournir une donnée de tension (V) commune auxdits N appareils de protection (4), et un détecteur de tension aval (10) disposé en aval de chacun des N appareils de protection (4), **caractérisé en ce que** l'on exploite les données de tension (V, v) fournies par lesdits détecteurs de tension (6, 10) pour disposer d'informations sur la présence ou l'absence de la tension (V) commune en amont des N appareils de protection (4) et sur la présence ou l'absence de la tension (v) individuelle en aval de chacun des N appareils de protection (4), et **en ce que** l'on détermine l'état individuel de chacun des N appareils de protection (4).

4. Procédé selon la revendication 3, dans lequel ladite installation électrique comporte deux niveaux hiérarchiques de distribution, un premier niveau alimenté par un tableau électrique principal et un second niveau alimenté par un tableau électrique terminal, chaque niveau de distribution comportant au moins un appareil de protection électrique (4), ladite installation comportant un unique détecteur de tension amont (6) disposé en amont dudit au moins un appareil de protection (4) du premier niveau et un détecteur de tension aval (10) disposé en aval dudit au moins un appareil de protection (4) du second niveau, **caractérisé en ce que** l'on exploite les données de tension (V, v) fournies par lesdits détecteurs de tension (6, 10) pour disposer d'informations sur la présence ou l'absence de la tension (V) commune en amont dudit premier niveau et sur la présence ou l'absence de la tension (v) en aval dudit second niveau, et **en ce que** l'on détermine l'état individuel d'au moins une partie desdits appareils de protection (4).

5. Procédé selon la revendication 3, dans lequel ladite installation électrique comporte un nombre X de niveaux hiérarchiques de distribution, un premier niveau alimenté par un tableau électrique principal, un nombre X-2 de niveaux intermédiaires alimentés par des tableaux électriques divisionnaires, et un dernier niveau alimenté par un tableau électrique terminal, chaque niveau de distribution comportant au moins un appareil de protection électrique (4), ladite installation comportant un unique détecteur de tension amont (6) disposé en amont dudit au moins un appareil de protection (4) du premier niveau et un détecteur de tension aval (10) disposé en aval dudit au moins un appareil de protection (4) du dernier niveau, **caractérisé en ce que** l'on exploite les données de tension (V, v) fournies par lesdits détecteurs de tension (6, 10) pour disposer d'informations sur la présence ou l'absence de la tension (V) commune en amont dudit premier niveau et sur la présence ou l'absence de la tension (v) en aval dudit dernier niveau, et **en ce que** l'on détermine l'état individuel d'au moins une partie desdits appareils de protection (4).

6. Procédé selon la revendication 5, dans lequel ladite installation comporte en outre un détecteur de tension aval (10) disposé en aval dudit au moins un appareil de protection (4) de chaque niveau intermédiaire, **caractérisé en ce que** l'on exploite en outre les données de tension (v) fournies par lesdits détecteurs de tension (10) pour disposer d'informations sur la présence ou l'absence de la tension (v) en aval dudit au moins un appareil de protection (4) de chaque niveau intermédiaire, et **en ce que** l'on détermine l'état individuel de chacun desdits appareils de protection (4) desdits niveaux intermédiaires.

7. Procédé selon l'une quelconque des revendications précédentes, dans lequel ledit détecteur de tension amont (6) et ledit détecteur de tension aval (10) sont des capteurs de présence de tension et/ou des capteurs de mesure de tension, **caractérisé en ce que** l'on exploite des images de la tension vues et/ou des valeurs de tension mesurées par lesdits détecteurs de tension (6, 10).

8. Procédé selon la revendication 7, **caractérisé en ce que** l'on utilise comme détecteur de tension amont (6) et/ou détecteur de tension aval (10) des capteurs sans contact.

9. Procédé selon la revendication 1, **caractérisé en ce que** l'on exploite une valeur de tension (Vm) mesurée par ledit détecteur de tension (6, 10) correspondant, et **en ce que** l'on compare ladite valeur de tension mesurée (Vm) audit seuil de tension (Vs) pour déterminer si la tension (V, v) est présente ou absente.

10. Dispositif de détection de l'état ouvert ou fermé d'un appareil de protection électrique (4) dans une installation électrique pour alimenter une charge (3) consommatrice d'énergie, ladite installation comportant un détecteur de tension amont (6) et un détecteur de tension aval (10) disposés respectivement en amont et en aval dudit appareil de protection (4) et un dispositif de mesure du courant (7) disposé en aval dudit au moins un appareil de protection (4) agencé pour détecter le courant (I) traversant ladite charge (3), ledit dispositif comportant une unité de traitement (5) agencée pour exploiter les données de tension (V, v) fournies par lesdits détecteurs de tension (6, 10) et disposer d'informations sur la présence ou l'absence de la tension (V) en amont et sur la présence ou l'absence de la tension (v) en aval dudit appareil de protection (4), et pour identifier si chacune des tensions (V, v) est présente ou absente, ladite unité de traitement (5) comporte un module de détermination de la présence de tension (12) agencé pour comparer lesdites données de tension (V, v) fournies par lesdits détecteurs de tension (6, 10) à une valeur de seuil de tension (Vs) en dessous de laquelle la tension est considérée comme absente, **caractérisé en ce que** ledit module de détermination de la présence de tension (12) est également agencé pour exploiter une valeur de courant (I) mesurée par ledit dispositif de mesure du courant (7) pour déterminer par calibration une valeur nominale de la tension (V, v) en amont et/ou en aval dudit appareil de protection (4) et fixer à partir de cette valeur nominale de la tension ledit seuil de tension (Vs), **en ce que** ladite unité de traitement (5) comporte un module de corrélation (13) desdites données de tension (V, v) comportant au moins une table de vérité (14) correspondant à au moins un type d'appareil de protection et agencé pour déterminer, en fonction de la présence ou de l'absence desdites tensions (V, v), si ledit appareil de protection (4) est dans un état ouvert, dans un état fermé, dans un état anormal ou dans un état indéterminé, **en ce que** ladite unité de traitement (5) est agencée pour exploiter la valeur de courant mesurée par ledit dispositif de mesure du courant et comporte une unité de comparaison (16) agencée pour comparer ladite valeur de courant mesurée à différents seuils de courant pour déterminer la cause de l'ouverture dudit appareil de protection (4) entre une ouverture volontaire et une ouverture accidentelle due à une surcharge ou à un court-circuit, et des moyens de communication agencés pour délivrer une information sur l'état dudit appareil de protection (4) à une centrale de supervision (20), et si ledit appareil de protection (4) est dans un état ouvert, la cause de l'ouverture.

11. Dispositif selon la revendication 10, ledit appareil de protection électrique (4) comportant plusieurs pôles (P1, P2, P3) et ladite installation comportant sur chacun des pôles (P1, P2, P3) un détecteur de tension amont (6) et un détecteur de tension aval (10) disposés respectivement en amont et en aval dudit appareil de protection (4), **caractérisé en ce que** ladite unité de traitement (5) est agencée pour exploiter les données de tension (V, v) fournies par lesdits détecteurs de tension (6, 10), pôle par pôle (P1, P2, P3), et disposer d'informations sur la présence ou l'absence de tension (V) en amont et sur la présence ou l'absence de tension (v) en aval dudit appareil de protection (4), et **en ce que** ledit module de corrélation (13) des données de tension (V, v) est agencé pour comparer lesdites données de tension (V, v) pôle par pôle et déterminer en outre si ledit appareil de protection (4) est dans un état ouvert incomplet.

12. Dispositif selon l'une quelconque des revendications 10 et 11, ladite installation électrique comportant un nombre N d'appareils de protection électrique (4), un unique détecteur de tension amont (6) disposé en amont des N appareils de protection (4) agencé pour fournir une donnée de tension (V) commune auxdits N appareils de protection (4), et un détecteur de tension aval (10) disposé en aval de chacun des N appareils de protection (4), **caractérisé en ce que** ladite unité de traitement (5) est agencée pour exploiter les données de tension (V, v) fournies par lesdits détecteurs de tension (6, 10), disposer d'informations sur la présence ou l'absence de la tension (V) commune amont des N appareils de protection (4) et sur la présence ou l'absence de la tension (v) individuelle en aval de chacun des N appareils de protection (4), et **en ce que** ledit module de corrélation (13) est agencé pour déterminer l'état individuel de chacun des N appareils de protection (4).

13. Dispositif selon la revendication 12, ladite installation électrique comportant deux niveaux hiérarchiques de distribution, un premier niveau alimenté par un tableau électrique principal et un second niveau alimenté par un tableau électrique terminal, chaque niveau de distribution comportant au moins un appareil de protection électrique (4), ladite installation comportant un unique détecteur de tension amont (6) disposé en amont dudit au moins un appareil de protection (4) du premier niveau et un détecteur de tension aval (10) disposé en aval dudit au moins un appareil de protection (4) du second niveau, **caractérisé en ce que** ladite unité de traitement (5) est agencée pour exploiter les données de tension (V, v) fournies par lesdits détecteurs de tension (6, 10), disposer d'informations sur la présence ou l'absence de la tension (V) commune en amont dudit premier niveau et sur la présence ou l'absence de la tension (v) en aval dudit second niveau, et **en ce que** ledit module de corrélation (13) est agencé pour déterminer l'état individuel d'au moins une partie desdits appareils de protection (4).

14. Dispositif selon la revendication 12, ladite installation électrique comportant un nombre X de niveaux hiérarchiques de distribution, un premier niveau alimenté par un tableau électrique principal, un nombre X-2 de niveaux intermédiaires alimentés par des tableaux électriques divisionnaires, et un dernier niveau alimenté par un tableau électrique terminal, chaque niveau de distribution comportant au moins un appareil de protection électrique (4), ladite installation comportant un unique détecteur de tension amont (6) disposé en amont dudit au moins un appareil de protection (4) du premier niveau et un détecteur de tension aval (10) disposé en aval dudit au moins un appareil de protection (4) du dernier niveau, **caractérisé en ce que** ladite unité de traitement (5) est agencée pour exploiter les données de tension (V, v) fournies par lesdits détecteurs de tension (6, 10), disposer d'informations sur la présence ou l'absence de la tension (V) commune en amont dudit premier niveau et sur la présence ou l'absence de la tension (v) en aval dudit dernier niveau, et **en ce que** ledit module de corrélation (13) est agencé pour déterminer l'état individuel d'au moins une partie desdits appareils de protection (4).

15. Dispositif selon la revendication 14, ladite installation comportant en outre un détecteur de tension aval (10) disposé en aval dudit au moins un appareil de protection (4) du chaque niveau intermédiaire, **caractérisé en ce que** ladite unité de traitement (5) est agencée pour exploiter en outre les données de tension (v) fournies par lesdits détecteurs de tension (10), disposer d'informations sur la présence ou l'absence de la tension (v) en aval dudit au moins un appareil de protection (4) de chaque niveau intermédiaire, et **en ce que** ledit module de corrélation (13) est agencé pour déterminer l'état individuel de chacun desdits appareils de protection (4) de chacun des niveaux intermédiaires.

16. Dispositif selon l'une quelconque des revendications 10 à 15, **caractérisé en ce que** ledit détecteur de tension amont (6) et ledit détecteur de tension aval (10) sont des capteurs de présence de tension et/ou des capteurs de mesure de tension et **en ce que** ladite unité de traitement (5) est agencée pour exploiter des images de la tension vues et/ou des valeurs de tension mesurées par lesdits détecteurs de tension (6, 10).

17. Dispositif selon la revendication 16, **caractérisé en ce que** ledit détecteur de tension amont (6) et/ou ledit détecteur de tension aval (10) sont des capteurs sans contact.

18. Dispositif selon l'une quelconque des revendications 10 à 17, **caractérisé en ce que** ladite unité de traitement (5) comporte en outre un module de synchronisation (11) agencé pour caler la fréquence l'échantillonnage desdites données de tension (V, v) et de courant (I) fournies par lesdits détecteurs de tension (6, 10) et par ledit dispositif de mesure du courant (7).

## Patentansprüche

1. Verfahren zum Erfassen des geöffneten oder geschlossenen Zustands eines Schutzgeräts (4) in einer elektrischen Anlage zur Versorgung einer energieverbrauchenden Last (3), wobei diese Anlage einen vorgeschalteten Spannungsdetektor (6) und einen nachgeschalteten Spannungsdetektor (10) enthält, die jeweils vor bzw. hinter diesem Schutzgerät (4) angeordnet sind, und eine Strommessvorrichtung (7) hinter diesem mindestens einen Schutzgerät (4) nachgeschaltet angeordnet und vorgesehen zur Erkennung des Stroms (I), der durch diese Last (3) fließt, Verfahren, bei dem die von diesen Spannungsdetektoren (6, 10) gelieferten Spannungsdaten(V, v) verwendet werden, um Informationen über das Vorhandensein oder Fehlen der Spannung (V) vor und das Vorhandensein oder Fehlen der Spannung (v) hinter diesem Schutzgerät (4) zu liefern, und um zu erkennen, ob jede der Spannungen (V, v) vorhanden ist oder fehlt, bei dem ein Spannungsgrenzwert (Vs) festgelegt wird, unter dem die Spannung (V, v) vor und/oder hinter diesem Schutzgerät (4) als vorhanden oder als fehlend betrachtet wird, **dadurch gekennzeichnet, dass** ein von dieser Strommessvorrichtung (7) gemessener Wert des Stroms (I) ausgewertet wird, um durch Kalibrierung einen Nennwert der Spannung (V, v) vor und/oder nach diesem Schutzgerät (4) zu bestimmen und ausgehend von diesem Spannungsnennwert diesen Spannungsgrenzwert (Vs) festzulegen, dadurch dass eine Korrelation zwischen diesen Spannungsdaten (V, v) und einer dem jeweiligen Schutzgerätetyp (4) entsprechenden Wahrheitstabelle (14) hergestellt wird, um in Abhängigkeit vom Vorhandensein oder dem Fehlen dieser Spannungen (V, v) festzustellen, ob sich das Schutzgerät (4) in einem offenen Zustand, in einem geschlossenen Zustand, in einem anormalen Zustand oder in einem unbestimmten Zustand befindet, bei dem die Spannung (V) davor und die Spannung (v) dahinter fehlen, und dadurch dass außerdem der von der erwähnten Strommessvorrichtung (7) gemessene Strom verwendet wird, um die Ursache der Öffnung des Schutzgerätes (4) festzustellen, ob es sich um eine absichtliche Öffnung oder eine unbeabsichtigte Öffnung aufgrund einer Überlast oder einem Kurzschluss handelt.

2. Verfahren nach Anspruch 1, bei dem das erwähnte elektrische Schutzgerät (4) mehrere Pole (P1, P2, P3) enthält, und die erwähnte Anlage an jedem Pol (P1, P2, P3) einen vorgeschalteten Spannungsdetektor (6) und einen nachgeschalteten Spannungsdetektor (10) enthält, die jeweils vor bzw. hinter dem erwähnten Schutzgerät (4) angeordnet sind, **dadurch gekennzeichnet, dass** die von diesen Spannungsdetektoren (6, 10) gelieferten Spannungsdaten (V, v), Pol für Pol (P1, P2, P 3) ausgewertet werden, um über Informationen zum Vorhandensein oder Fehlen von vorgeschalteter Spannung (V) und über das Vorhandensein oder Fehlen von nachgeschalteter Spannung (v) bei diesem Schutzgerät (4) zu verfügen, dadurch, dass die Spannungsdaten (V, v) Pol für Pol verglichen werden und dass außerdem bestimmt wird, ob dieses Schutzgerät (4) sich in einem unvollständig geöffneten Zustand befindet, in dem die vorgeschaltete Spannung (V) an allen Polen (P1, P2, P3) vorhanden ist und die nachgeschaltete Spannung (v) an bestimmten Polen fehlt.

3. Verfahren nach einem beliebigen der Ansprüche 1 und 2, bei dem diese elektrische Anlage eine Anzahl N an Schutzgeräten (4), einen einzigen vorgeschalteten Spannungsdetektor (6), angeordnet vor den N Schutzgeräten (4), um eine Spannungsangabe (V) zu liefern, die den N Schutzgeräten (4) gemeinsam ist und einen nachgeschalteten Spannungsdetektor (10), angeordnet hinter jedem der N Schutzgeräte (4), enthält, **dadurch gekennzeichnet, dass** die von diesen Spannungsdetektoren (6, 10) gelieferten Spannungsdaten (V, v) verwendet werden, um über Informationen über das Vorhandensein oder Fehlen der gemeinsamen Spannung (V) vor den N Schutzgeräten (4) und das Vorhandensein oder Fehlen der Einzelspannung (v) hinter jedem dieser N Schutzgeräte (4) zu verfügen und dadurch dass der einzelne Zustand jedes dieser N Schutzgeräte (4) bestimmt wird.

4. Verfahren nach Anspruch 3, bei dem diese elektrische Anlage zwei hierarchische Verteilerebenen enthält, eine erste Ebene, die von einer Hauptschalttafel versorgt wird, und eine zweite Ebene, die von einer Endverteilerschalttafel versorgt wird, wobei jede Verteilerebene mindestens ein elektrisches Schutzgerät (4) enthält, wobei die erwähnte Anlage einen einzigen vorgeschalteten Spannungsdetektor (6), angeordnet vor diesem mindestens einen Schutzgerät (4) der ersten Ebene und einen nachgeschalteten Spannungsdetektor (10), angeordnet hinter diesem mindestens einen Schutzgerät (4) der zweiten Ebene enthält, **dadurch gekennzeichnet, dass** die von diesen Spannungsdetektoren (6, 10) gelieferten Spannungsdaten (V, v) ausgewertet werden, um über Informationen zum Vorhandensein oder Fehlen von gemeinsamer Spannung (V) vor dieser ersten Ebene und über das Vorhandensein oder Fehlen von Spannung (v) hinter dieser zweiten Ebene zu verfügen, und dadurch, dass der individuelle Zustand mindestens eines Teils dieser Schutzgeräte (4) bestimmt wird.

5. Verfahren nach Anspruch 3, bei dem diese elektrische Anlage eine Anzahl X hierarchischer Verteilerebenen enthält, wobei eine erste Ebene von einer Hauptschalttafel versorgt wird, wobei eine Anzahl X-2 an Zwischenebenen von Trennverteilerschalttafeln versorgt wird, und wobei eine letzte Ebene wird von einer Endverteilerschalttafel versorgt wird, wobei jede Verteilerebene mindestens ein elektrisches Schutzgerät (4) enthält, wobei die erwähnte Anlage dabei einen einzigen vorgeschalteten Spannungsdetektor (6), angeordnet vor diesem mindestens einen Schutzgerät (4) der ersten Ebene und einen nachgeschalteten Spannungsdetektor (10), angeordnet hinter diesem mindestens einen Schutzgerät (4) der letzten Ebene enthält, **dadurch gekennzeichnet, dass** die von diesen Spannungsdetektoren (6, 10) gelieferten Spannungsdaten (V, v), ausgewertet werden, um über Informationen zum Vorhandensein oder Fehlen von gemeinsamer vorgeschalteter Spannung (V) vor dieser ersten Ebene und über das Vorhandensein oder Fehlen von nachgeschalteter Spannung (v) hinter dieser letzten Ebene zu verfügen, und dadurch, dass der individuelle Zustand mindestens eines Teils dieser Schutzgeräte (4) bestimmt wird.

6. Verfahren nach Anspruch 5, bei dem diese elektrische Anlage außerdem einen nachgeschalteten Spannungsdetektor (10) umfasst, der hinter diesem mindestens einen Schutzgerät (4) jeder Zwischenebene angeordnet ist, **dadurch gekennzeichnet, dass** die von diesen Spannungsdetektoren (10) gelieferten Spannungsdaten (v) ausgewertet werden, um über Informationen zum Vorhandensein oder Fehlen von Spannung (v) hinter diesem mindestens einen Schutzgerät (4) jeder Zwischenebene zu verfügen, und dadurch, dass der individuelle Zustand jedes dieser Schutzgeräte (4) der erwähnten Zwischenebenen bestimmt wird.

7. Verfahren nach einem der vorangehenden Ansprüche, bei dem der erwähnte vorgeschaltete Spannungsdetektor (6) und der erwähnte nachgeschaltete Spannungsdetektor (10) Spannungsmelder und/oder Spannungsanzeigen sind, **dadurch gekennzeichnet, dass** von diesen Spannungsanzeigen (6, 10) erfasste Spannungsbilder und/oder gemessene Spannungswerte ausgewertet werden.

8. Verfahren nach Anspruch 7, **dadurch gekennzeichnet, dass** als vorgeschalteter Spannungsdetektor (6) und/oder nachgeschalteter Spannungsdetektor (10) kontaktfreie Melder eingesetzt werden.

9. Verfahren nach Anspruch 1, **dadurch gekennzeichnet, dass** ein von dieser zugehörigen Spannungsanzeige (6, 10) gemessener Spannungswert (Vm) ausgewertet wird und dass dieser gemessene Spannungswert (Vm) mit dem erwähnten Spannungsgrenzwert (Vs) verglichen wird, um festzustellen, ob die Spannung (V, v) vorhanden ist oder fehlt.

10. Vorrichtung zum Erfassen des geöffneten oder geschlossenen Zustands eines Schutzgeräts (4) in einer elektrischen Anlage zur Versorgung einer energieverbrauchenden Last (3), wobei diese Anlage einen vorgeschalteten Spannungsdetektor (6) und einen nachgeschalteten Spannungsdetektor (10) enthält, die jeweils vor und hinter diesem Schutzgerät (4) angeordnet sind, sowie eine Strommessvorrichtung (7), die hinter diesem mindestens einen Schutzgerät (4) angeordnet ist und vorgesehen ist zur Erkennung des Stroms (I), der durch diese Last (3) fließt, dabei enthält diese Vorrichtung eine Behandlungseinheit (5), vorgesehen zur Auswertung der von diesen Spannungsdetektoren (6, 10) gelieferten Spannungsdaten (V, v), um über Informationen über das Vorhandensein oder Fehlen der Spannung (V) vor und das Vorhandensein oder Fehlen der Spannung (v) hinter diesem Schutzgerät (4) zu verfügen, und, um zu erkennen, ob jede der Spannungen (V, v) vorhanden ist oder fehlt, enthält diese Bearbeitungseinheit (5) ein Modul zur Bestimmung des Vorhandenseins von Spannung (12), vorgesehen, um diese Spannungsdaten (V, v), die von diesen Spannungsdetektoren (6, 10) geliefert werden mit einem Spannungsgrenzwert (Vs) zu vergleichen, unterhalb dem diese Spannung als fehlend angesehen wird, **dadurch gekennzeichnet, dass** dieses Modul zur Bestimmung des Vorhandenseins von Spannung (12) auch dazu vorgesehen ist, einen von der erwähnten Strommessvorrichtung (7) gemessenen Stromwert (1) zu nutzen, um durch Kalibrierung einen Nennwert der Spannung (V, v) vor und/oder hinter diesem Schutzgerät (4) zu bestimmen und ausgehend von diesem Spannungsnennwert diesen Spannungsgrenzwert (Vs) festzulegen, dadurch dass diese Bearbeitungseinheit (5) ein Korrelationsmodul (13) für diese Spannungsdaten (V, v) enthält, das mindestens eine Wahrheitstabelle (14) enthält, die mindestens einem Schutzgerätetyp (4) entspricht und dafür vorgesehen ist, um in Abhängigkeit vom Vorhandensein oder dem Fehlen dieser Spannungen (V, v) festzustellen, ob sich dieses Schutzgerät (4) in einem offenen Zustand, in einem geschlossenen Zustand, in einem anormalen Zustand oder in einem unbestimmten Zustand befindet, dadurch dass diese Bearbeitungseinheit (5) dazu vorgesehen ist, um den von der erwähnten Strommessvorrichtung gemessenen Strom zu verwenden und eine Vergleichseinheit (16) enthält, die dazu vorgesehen ist, diesen gemessenen Stromwert mit verschiedenen Stromgrenzwerten zu vergleichen, um die Ursache der Öffnung des Schutzgerätes (4) festzustellen, ob es sich um eine absichtliche Öffnung oder eine unbeabsichtigten Öffnung aufgrund einer Überlast oder einem Kurzschluss handelt und Kommunikationsmittel, vorgesehen um eine Information über den Zustand dieses Schutzgerätes (4) an eine Überwachungszentrale (20) zu übermitteln, und wenn sich dieses Schutzgerät (4) in einem offenen Zustand befindet, auch die Ursache der Öffnung.

11. Vorrichtung nach Anspruch 10, bei dem das erwähnte elektrische Schutzgerät (4) mehrere Pole (P1, P2, P3) enthält, und die erwähnte Anlage an jedem Pol (P1, P2, P3) einen vorgeschalteten Spannungsdetektor (6) und einen nachgeschalteten Spannungsdetektor (10) enthält, die jeweils vor und hinter dem erwähnten Schutzgerät (4) angeordnet sind, **dadurch gekennzeichnet, dass** diese Bearbeitungseinheit (5) dazu vorgesehen ist, um die von diesen Spannungsdetektoren (6, 10) gelieferten Spannungsdaten (V, v), Pol für Pol (P1, P2, P 3) auszuwerten, um über Informationen zum Vorhandensein oder Fehlen von Spannung (V) vor und über das Vorhandensein oder Fehlen von Spannung (v) hinter diesem Schutzgerät (4) zu verfügen, dadurch, dass das erwähnte Korrelationsmodul (13) der Spannungsdaten (V, v) dazu vorgesehen ist, diese Spannungsdaten (V, v) Pol für Pol zu vergleichen werden und außerdem zu bestimmen, ob sich dieses Schutzgerät (4) in einem unvollständig geöffneten Zustand befindet.

12. Vorrichtung nach einem der Ansprüche 10 und 11, bei dem diese elektrische Anlage eine Anzahl N an Schutzgeräten (4) enthält, einen einzigen vorgeschalteten Spannungsdetektor (6), angeordnet vorgeschaltet vor den N Schutzgeräten (4), vorgesehen um eine Spannungsangabe (V) zu liefern, die den N Schutzgeräten (4) gemeinsam ist, und einen nachgeschalteten Spannungsdetektor (10), angeordnet hinter jedem der N Schutzgeräte (4), **dadurch gekennzeichnet, dass** die erwähnte Bearbeitungseinheit (5) dazu vorgesehen ist, um die von diesen Spannungsdetektoren (6, 10) gelieferten Spannungsdaten (V, v) auszuwerten, um über Informationen über das Vorhandensein oder Fehlen der gemeinsamen Spannung (V), vorgeschaltet vor den N Schutzgeräten (4) und das Vorhandensein oder Fehlen der Einzelspannung (v) hinter jedem dieser N Schutzgeräte (4) zu verfügen und dass das erwähnte Korrelationsmodul (13) dazu vorgesehen ist, den einzelnen Zustand jedes dieser N Schutzgeräte (4) zu bestimmen.

13. Vorrichtung nach Anspruch 12, bei dem diese elektrische Anlage zwei hierarchische Verteilerebenen enthält, eine erste Ebene, die von einer Hauptschalttafel versorgt wird, und eine zweite Ebene, die von einer Endverteilerschalttafel versorgt wird, wobei jede Verteilerebene mindestens ein elektrisches Schutzgerät (4) enthält, wobei die erwähnte Anlage einen einzigen vorgeschalteten Spannungsdetektor (6), angeordnet vor diesem mindestens einen Schutzgerät (4) der ersten Ebene und einen nachgeschalteten Spannungsdetektor (10), angeordnet hinter diesem mindestens einen Schutzgerät (4) der zweiten Ebene enthält, **dadurch gekennzeichnet, dass** diese Bearbeitungseinheit (5) dazu vorgesehen ist, die von diesen Spannungsdetektoren (6, 10) gelieferten Spannungsdaten (V, v), auszuwerten, um über Informationen zum Vorhandensein oder Fehlen von gemeinsamer vorgeschalteter Spannung (V) vor dieser ersten Ebene und über das Vorhandensein oder Fehlen von Spannung (v) hinter dieser zweiten Ebene zu verfügen, und dadurch, dass das erwähnte Korrelationsmodul (13) dazu vorgesehen ist, den individuellen Zustand mindestens eines Teils dieser Schutzgeräte (4) zu bestimmen.

14. Vorrichtung nach Anspruch 12, bei dem diese elektrische Anlage eine Anzahl X hierarchischer Verteilerebenen enthält, wobei eine erste Ebene von einer Hauptschalttafel versorgt wird, wobei eine Anzahl X-2 an Zwischenebenen von Trennverteilerschalttafeln versorgt wird, und wobei eine letzte Ebene von einer Endverteilerschalttafel versorgt wird, wobei jede Verteilerebene mindestens ein elektrisches Schutzgerät (4) enthält, wobei die erwähnte Anlage einen einzigen vorgeschalteten Spannungsdetektor (6), angeordnet vor diesem mindestens einen Schutzgerät (4) der ersten Ebene und einen nachgeschalteten Spannungsdetektor (10), angeordnet hinter diesem mindestens einen Schutzgerät (4) der letzten Ebene enthält, **dadurch gekennzeichnet, dass** diese Bearbeitungseinheit (5) dazu vorgesehen ist, die von diesen Spannungsdetektoren (6, 10) gelieferten Spannungsdaten (V, v), auszuwerten, um über Informationen zum Vorhandensein oder Fehlen von gemeinsamer Spannung (V) vor dieser ersten Ebene und über das Vorhandensein oder Fehlen von Spannung (v) hinter dieser letzten Ebene zu verfügen, und dadurch, dass das erwähnte Korrelationsmodul (13) dazu vorgesehen ist, den individuellen Zustand mindestens eines Teils dieser Schutzgeräte (4) zu bestimmen.

15. Vorrichtung nach Anspruch 14, wobei diese Anlage außerdem einen nachgeschalteten Spannungsdetektor (10) enthält, angeordnet hinter diesem mindestens einen Schutzgerät (4) jeder Zwischenebene, **dadurch gekennzeichnet, dass** diese Bearbeitungseinheit (5) dazu vorgesehen ist, außerdem die von diesen Spannungsdetektoren (10) gelieferten Spannungsdaten (v), auszuwerten, um über Informationen zum Vorhandensein oder Fehlen von Spannung (v) hinter diesem mindestens einen Schutzgerät (4) jeder Zwischenebene zu verfügen, und dadurch, dass das erwähnte Korrelationsmodul (13) dazu vorgesehen ist, den individuellen Zustand mindestens eines Teils dieser Schutzgeräte (4) jedes der Zwischenebenen zu bestimmen.

16. Verfahren nach irgendeinem der vorangehenden Ansprüche 10 bis 15, **dadurch gekennzeichnet, dass** der erwähnte vorgeschaltete Spannungsdetektor (6) und der erwähnte nachgeschaltete Spannungsdetektor (10) Spannungsmelder und/oder Spannungsanzeigen sind, und dadurch, dass die erwähnte Bearbeitungseinheit (5) dazu vorgesehen ist, von diesen Spannungsanzeigen (6, 10) erfasste Spannungsbilder und/oder gemessene Spannungswerte auszuwerten.

17. Vorrichtung nach Anspruch 16, **dadurch gekennzeichnet, dass** als vorgeschalteter Spannungsdetektor (6) und/oder nachgeschalteter Spannungsdetektor (10) kontaktfreie Melder eingesetzt werden.

18. Vorrichtung nach einem der Ansprüche 10 bis 17, **dadurch gekennzeichnet, dass** diese Bearbeitungseinheit (5) außerdem ein Synchronisationsmodul (11) enthält, vorgesehen zur Einstellung der Eichfrequenz dieser Spannungs- (V, v) und Stromdaten (I), die von diesen Spannungsdetektoren (6, 10) und von dieser Strommessvorrichtung (7) geliefert werden.

## Claims

1. Method for detecting the open or closed state of an electrical protection appliance (4) in an electrical installation for powering an energy-consuming load (3), said installation comprising an upstream voltage detector (6) and a downstream voltage detector (10) respectively disposed upstream and downstream of said protection appliance (4), and a current measuring device (7) disposed downstream of said at least one protection appliance (4) designed to detect the current (I) passing through said load (3), method wherein the voltage data (V, v) provided by said voltage detectors (6, 10) is used to obtain information regarding the presence or absence of voltage (V) upstream and regarding the presence or absence of voltage (v) downstream of said protection appliance (4), and in order to identify whether each of the voltages (V, v) is present or absent, a voltage threshold (Vs) is set, below which the voltage (V, v) upstream and/or downstream of said protection appliance (4) is considered to be absent, **characterised in that** a current value (I) measured by said current measuring device (7) is used to determine, by calibration, a nominal value of the voltage (V, v) upstream and/or downstream of said protection appliance (4) and set said voltage threshold (Vs) based on this nominal voltage value, **in that** a correlation is established between said voltage data (V, v) and a truth table (14) corresponding to the type of protection appliance (4) concerned to determine, depending on the presence or absence of said voltages (V, v), whether said protection appliance (4) is in an open state, in a closed state, in an abnormal state or in an undetermined state wherein the upstream voltage (V) and the downstream voltage (v) are absent, and **in that** the current value measured by said current measuring device (7) is also used to determine the cause of the opening of said protection appliance (4) between a deliberate opening and an accidental opening caused by an overload or a short-circuit.

2. Method according to claim 1, wherein said electrical protection appliance (4) comprises a plurality of poles (PI, P2, P3) and said installation comprises, on each of the poles (PI, P2, P3) an upstream voltage detector (6) and a downstream voltage detector (10) respectively disposed upstream and downstream of said protection appliance (4), **characterised in that** the voltage data (V, v) provided by said voltage detectors (6, 10), pole by pole (PI, P2, P3), is used to obtain information regarding the presence or absence of voltage (V) upstream and regarding the presence or absence of voltage (v) downstream of said protection appliance (4), **in that** the voltage data (V, v) is compared, pole by pole, and **in that** it is also determined whether said protection appliance (4) is in an incomplete open state wherein the upstream voltage (V) is present across all poles (PI, P2, P3) and the downstream voltage (v) is absent across certain poles.

3. Method according to any of claims 1 and 2, wherein said electrical installation comprises a number N of electrical protection appliances (4), a single upstream voltage detector (6) disposed upstream of the N protection appliances (4) to provide a voltage datum (V) common to said N protection appliances (4), and a downstream voltage detector (10) disposed downstream of each of the N protection appliances (4), **characterised in that** the voltage data (V, v) provided by said voltage detectors (6, 10) is used to obtain information regarding the presence or absence of the common voltage (V) upstream of the N protection appliances (4) and regarding the presence or absence of the individual voltage (v) downstream of each of the N protection appliances (4), and **in that** the individual state of each of the N protection appliances (4) is determined.

4. Method according to claim 3, wherein said electrical installation comprises two ranked distribution levels, a first level powered by a main switchboard and a second level powered by a final distribution board, each distribution level comprising at least one electrical protection appliance (4), said installation comprising a single upstream voltage detector (6) disposed upstream of said at least one protection appliance (4) of the first level and a downstream voltage detector (10) disposed downstream of said at least one protection appliance (4) of the second level, **characterised in that** the voltage data (V, v) provided by said voltage detectors (6, 10) is used to obtain information regarding the presence or absence of the common voltage (V) upstream of said first level and regarding the presence or absence of voltage (v) downstream of said second level, and **in that** the individual state of at least a part of said protection appliances (4) is determined.

5. Method according to claim 3, wherein said electrical installation comprises a number X of ranked distribution levels, a first level powered by a main switchboard, a number X-2 of intermediate levels powered by sub-main distribution boards, and a final level powered by a final distribution board, each distribution level comprising at least one electrical protection appliance (4), said installation comprising a single upstream voltage detector (6) disposed upstream of said at least one protection appliance (4) of the first level and a downstream voltage detector (10) disposed downstream of said at least one protection appliance (4) of the final level, **characterised in that** the voltage data (V, v) provided by said voltage detectors (6, 10) is used to obtain information regarding the presence or absence of the common voltage (V) upstream of said first level and regarding the presence or absence of voltage (v) downstream of said final level, and **in that** the individual state of at least a part of said protection appliances (4) is determined.

6. Method according to claim 5, wherein said installation further comprises a downstream voltage detector (10) disposed downstream of said at least one protection appliance (4) of each intermediate level, **characterised in that** the voltage data (v) provided by said voltage detectors (10) is also used to obtain information regarding the presence or absence of voltage (v) downstream of said at least one protection appliance (4) of each intermediate level, and **in that** the individual state of each of said protection appliances (4) of said intermediate levels is determined.

7. Method according to any of the preceding claims, wherein said upstream voltage detector (6) and said downstream voltage detector (10) are voltage presence sensors and/or voltage measurement sensors, **characterised in that** voltage images viewed and/or voltage values measured by said voltage detectors (6, 10) are used.

8. Method according to claim 7, **characterised in that** non-contact sensors are used as the upstream voltage detector (6) and/or downstream voltage detector (10).

9. Method according to claim 1, **characterised in that** a voltage value (Vm) measured by said corresponding voltage detector (6, 10) is used, and **in that** said measured voltage value (Vm) is compared with said voltage threshold (Vs) to determine whether the voltage (V, v) is present or absent.

10. Device for detecting the open or closed state of an electrical protection appliance (4) in an electrical installation for powering an energy-consuming load (3), said installation comprising an upstream voltage detector (6) and a downstream voltage detector (10) respectively disposed upstream and downstream of said protection appliance (4), and a current measuring device (7) disposed downstream of said at least one protection appliance (4) designed to detect the current (I) passing through said load (3), said device comprising a processing unit (5) designed to use the voltage data (V, v) provided by said voltage detectors (6, 10) and obtain information regarding the presence or absence of voltage (V) upstream and regarding the presence or absence of voltage (v) downstream of said protection appliance (4), and in order to identify whether each of the voltages (V, v) is present or absent, said processing unit (5) comprises a voltage presence determination module (12) designed to compare said voltage data (V, v) provided by said voltage detectors (6, 10) with a voltage threshold value (Vs) below which the voltage is considered to be absent, **characterized in that** said voltage presence determination module (12) is also designed to use a current value (I) measured by said current measuring device (7) to determine, by calibration, a nominal value of the voltage (V, v) upstream and/or downstream of said protection appliance (4) and set said voltage threshold (Vs) based on this nominal voltage value, **in that** said processing unit (5) comprises a module (13) for correlating said voltage data (V, v), comprising at least one truth table (14) corresponding to at least one type of protection appliance and designed to determine, depending on the presence or absent of said voltages (V, v), whether said protection appliance (4) is in an open state, in a closed state, in an abnormal state or in an undetermined state, **in that** said processing unit (5) is designed to use the current value measured by said current measuring device and comprises a comparison unit (16) designed to compare said measured current value with different current thresholds to determine the cause behind the opening of said protection appliance (4) from a deliberate opening and an accidental opening caused by an overload or a short-circuit, and communication means designed to transmit information regarding the state of said protection appliance (4) to a central monitoring station (20), and if said protection appliance (4) is in an open state, the cause behind the opening.

11. Device according to claim 10, said electrical protection appliance (4) comprising a plurality of poles (PI, P2, P3) and said installation comprising, on each of the poles (PI, P2, P3) an upstream voltage detector (6) and a downstream voltage detector (10) respectively disposed upstream and downstream of said protection appliance (4), **characterised in that** said processing unit (5) is designed to use the voltage data (V, v) provided by said voltage detectors (6, 10), pole by pole (PI, P2, P3), and obtain information regarding the presence or absence of voltage (V) upstream and regarding the presence or absence of voltage (v) downstream of said protection appliance (4), and **in that** said module (13) for correlating the voltage data (V, v) is designed to compare said voltage data (V, v), pole by pole, and further determine whether said protection appliance (4) is in an incomplete open state.

12. Device according to any of claims 10 and 11, said electrical installation comprising a number N of electrical protection appliances (4), a single upstream voltage detector (6) disposed upstream of the N protection appliances (4) designed to provide a voltage datum (V) common to said N protection appliances (4), and a downstream voltage detector (10) disposed downstream of each of the N protection appliances (4), **characterised in that** said processing unit (5) is designed to use the voltage data (V, v) provided by said voltage detectors (6, 10), to obtain information regarding the presence or absence of the common voltage (V) upstream of the N protection appliances (4) and regarding the presence or absence of the individual voltage (v) downstream of each of the N protection appliances (4), and **in that** said correlation module (13) is designed to determine the individual state of each of the N protection appliances (4).

13. Device according to claim 12, said electrical installation comprising two ranked distribution levels, a first level powered by a main switchboard and a second level powered by a final distribution board, each distribution level comprising at least one electrical protection appliance (4), said installation comprising a single upstream voltage detector (6) disposed upstream of said at least one protection appliance (4) of the first level and a downstream voltage detector (10) disposed downstream of said at least one protection appliance (4) of the second level, **characterised in that** said processing unit (5) is designed to use the voltage data (V, v) provided by said voltage detectors (6, 10), to obtain information regarding the presence or absence of the common voltage (V) upstream of said first level and regarding the presence or absence of voltage (v) downstream of said second level, and **in that** said correlation module (13) is designed to determine the individual state of at least a part of said protection appliances (4).

14. Device according to claim 12, said electrical installation comprising a number X of ranked distribution levels, a first level powered by a main switchboard, a number X-2 of intermediate levels powered by sub-main distribution boards, and a final level powered by a final distribution board, each distribution level comprising at least one electrical protection appliance (4), said installation comprising a single upstream voltage detector (6) disposed upstream of said at least one protection appliance (4) of the first level and a downstream voltage detector (10) disposed downstream of said at least one protection appliance (4) of the final level, **characterised in that** said processing unit (5) is designed to use the voltage data (V, v) provided by said voltage detectors (6, 10), to obtain information regarding the presence or absence of the common voltage (V) upstream of said first level and regarding the presence or absence of voltage (v) downstream of said final level, and **in that** said correlation module (13) is designed to determine the individual state of at least a part of said protection appliances (4).

15. Device according to claim 14, said installation further comprising a downstream voltage detector (10) disposed downstream of said at least one protection appliance (4) of each intermediate level, **characterised in that** said processing unit (5) is designed to further use the voltage data (v) provided by said voltage detectors (10), to obtain information regarding the presence or absence of voltage (v) downstream of said at least one protection appliance (4) of each intermediate level, and **in that** said correlation module (13) is designed to determine the individual state of each of said protection appliances (4) of each of the intermediate levels.

16. Device according to any of claims 10 to 15, **characterised in that** said upstream voltage detector (6) and said downstream voltage detector (10) are chosen from voltage presence sensors and/or voltage measurement sensors, and **in that** said processing unit (5) is designed to use voltage images viewed and/or voltage values measured by said voltage detectors (6, 10).

17. Device according to claim 16, **characterised in that** said upstream voltage detector (6) and/or said downstream voltage detector (10) are non-contact sensors.

18. Device according to any of claims 10 to 17, **characterised in that** said processing unit (5) further comprises a synchronisation module (11) designed to bring into line the sampling frequency of said voltage (V, v) and current (I) data provided by said voltage detectors (6, 10) and by said current measuring device (7).
